(19) Europäisches Patentamt
European Patent Office
Office européen des brevets

(11) **EP 3 309 827 B1**

(12) **EUROPEAN PATENT SPECIFICATION**

(45) Date of publication and mention
of the grant of the patent:
**05.08.2020  Bulletin 2020/32**

(21) Application number: **16807069.6**

(22) Date of filing: **13.05.2016**

(51) Int Cl.:
*H01L 23/473* (2006.01)        *H01L 23/36* (2006.01)
*H05K 7/20* (2006.01)          *H01L 23/367* (2006.01)
*H01L 21/48* (2006.01)

(86) International application number:
**PCT/JP2016/002357**

(87) International publication number:
**WO 2016/199352 (15.12.2016 Gazette 2016/50)**

(54) **SEMICONDUCTOR DEVICE**

HALBLEITERBAUELEMENT

DISPOSITIF À SEMI-CONDUCTEUR

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **12.06.2015  JP 2015119459**

(43) Date of publication of application:
**18.04.2018  Bulletin 2018/16**

(73) Proprietor: **DENSO CORPORATION**
**Kariya-city, Aichi**
**448-8661 (JP)**

(72) Inventors:
• **ISHINO, Hiroshi**
**Kariya-city**
**Aichi 448-8661 (JP)**

• **IKEGAME, Atsushi**
**Kariya-city**
**Aichi 448-8661 (JP)**

(74) Representative: **Winter, Brandl, Fürniss, Hübner,
Röss, Kaiser, Polte - Partnerschaft mbB
Patent- und Rechtsanwaltskanzlei
Alois-Steinecker-Straße 22
85354 Freising (DE)**

(56) References cited:
JP-A- H0 745 762        JP-A- 2005 254 417
JP-A- 2007 123 547      JP-A- 2007 208 154
JP-U- S6 296 854        US-A1- 2011 079 376
US-A1- 2013 192 329

**Description**

CROSS REFERENCE TO RELATED APPLICATIONS

This application is based on Japanese Patent Application No. 2015-119459 filed on June 12, 2015.

TECHNICAL FIELD

The present disclosure relates to a semiconductor device having a structure to cool a semiconductor module provided with a heater element by a cooler.

BACKGROUND ART

An amount of heat generated by a power element provided to a semiconductor module is increasing as an electric system achieves a higher output. Thermal resistance Rth is expressed by Equation (1) as follows:

$$\text{Rth (°C/W)} = \Delta Tj \div P \ \dots \ (1)$$

where $\Delta Tj$ is a heat generation temperature and P is an amount of heat generation of the power element as a heater element.

Equation (1) above indicates that given that an amount of heat generation is same, then $\Delta Tj$ becomes higher in a semiconductor module having lower thermal resistance. However, when the thermal resistance is high, a high current cannot be passed due to an upper temperature limit. Hence, in order to pass a desired output (for example, 100 Arms), it becomes necessary to connect elements in parallel or increase an element size, which in turn increases an area of a chip forming the power element and hence a cost. That is, due to a relationship that a cost increases as the thermal resistance rises, it is crucial to reduce a size of an element by decreasing a heat generation temperature of the element by enhancing radiation efficiency.

In a semiconductor device having a semiconductor module, a radiator plate provided with fin portions is disposed to the semiconductor module and a cooler is disposed to cover the fin portions in order to enhance radiation efficiency of the semiconductor module. Radiation from the semiconductor module is promoted by forcing a refrigerant to flow through an inner space of the cooler, and radiation efficiency is further enhanced by providing the radiator plate to the semiconductor module.

For example, the radiator plate may be a metal plate from which the fin portions are sliced and folded up (skived) as described in Patent Literature 1. The fin portions are formed by skiving with a skiving tool having a blade with a straight cutting edge or a toothed cutting edge. Hence, a linear fin portion or multiple equally-spaced fin portions are provided at a time.

The semiconductor device may have another structure, according to which a cylindrical tube portion having a radiator plate provided with multiple straight fins is inserted from an opening of a cooling base provided with a refrigerant passage, and the tube portion is fixed to the cooling base with a flange portion provided to the tube portion at a rear end in an insertion direction. A seal member is provided between the flange portion and the cooling base and the opening of the cooling base is hermetically closed with the flange portion and the seal member. By forcing a refrigerant to flow the refrigerant passage provided inside the cooling base, the refrigerant flows by hitting against the straight fins. High radiation efficiency can be thus achieved.

However, in a configuration in which the fin portions are formed by skiving with a skiving tool having a blade with a straight cutting edge or a toothed cutting edge as in Patent Literature 1, a heat-transfer surface is enlarged by increasing a surface area. Hence, the refrigerant flows in a direction perpendicular to a skiving direction of the fin portions. That is, linear or equally-spaced fin portions are disposed in multiple rows in parallel and the refrigerant flows by passing through spaces among the fin portions in multiple rows. The refrigerant thus flows homogeneously, which makes it difficult to enhance cooling efficiency. Situations are alike in an air cooling method using a gas-phase refrigerant, such as air, as the refrigerant and in a water-cooling method using a liquid-phase refrigerant, such as water, as the refrigerant.

In the configuration in which the tube portion having the radiator plate provided with multiple straight fins is inserted into the cooling base, it is necessary to provide a clearance between tip ends of the straight fins and an inner wall surface of the refrigerant passage for the tube portion to be inserted into the refrigerant passage in the cooling base. However, the refrigerant passes through the clearance as a bypass passage to bypass the fin portions. Accordingly, thermal conductivity decreases and radiation efficiency deteriorates. In addition, because the straight fins are provided by molding, a surface of the radiator plate is not a flat plane in the first place. Hence, a bonding state of element portions is difficult to inspect by a scanning acoustic tomograph (SAT).

PRIOR ART LITERATURES

PATENT LITERATURE

Patent Literature 1: JP-2005-216975-A

Document US 2011/079376 A1 describes a cold plate for fixing to an electronic equipment, which includes an enclosure with an inlet, an outlet, a base and a lid. The inlet and outlet are in fluid communication, so fluid can flow from the inlet though the enclosure to the outlet. The base is formed from a base plate, and the base plate includes an island facing into the enclosure. A plurality of pins extends from the island toward the lid. The pins can have a spiral shape, where the cross sectional profile of the pins change along the length of the pin.

Document JP 2007 208154 A describes a cooling device for an electronic equipment, wherein the channel of a refrigerant liquid circulated inside is formed by a wall piece in an integral structure by the same material cut, and raised from a base material having the thermal conductivity of one or both of a heat-exchange substrate and a heat exchanger frame body in the heat exchanger of the cooling device. The plane of the wall piece is curved for composing as nearly parallel circulation wall piece groups in the cooling device.

Document JP 2007 123547 A describes a package for an electronic part capable of obtaining a high heat-dissipating effect by integrally fitting a liquid-cooled heat exchanger to a package. In the package, a recess for housing the electronic part is indented and formed on one surface side of a metal plate. In the package, a hollow section formed in a sealed structure by the covering of a member to be covered is formed on the other surface side of the package. In the package, a large number of strips of trenches are formed in the hollow section while the liquid-cooled heat exchanger sealing a working fluid in itself is formed in the hollow section.

Document US 2013/0192329 A1 describes a protrusion forming device including a holding portion holding an object, a tool bit having a cutting portion for cutting the object, and a drive portion for driving the tool bit. The tool bit is movable along a cut-in pathway so that the cutting portion is inserted into the object. The cutting portion is movable along a further-cut pathway so as to form a protrusion part that is cut in a linear shape and is connected to the object. The tool bit continuously contacts the protrusion part while moving along a forming pathway such that the protrusion part extends perpendicular to an outer surface of the object.

SUMMARY OF INVENTION

It is an object of the present disclosure to provide a semiconductor device using a skived fin portion and thereby having capabilities of having a flat plane as a surface before a fin portion is formed by skiving and cooling a semiconductor module at higher cooling efficiency. The object is solved by the features of independent claim 1. The dependent claims are directed to preferred embodiments of the invention.

According to an aspect of the present disclosure, a semiconductor device includes: at least one semiconductor module having a semiconductor element functioning as a heater element, a resin mold having a plate shape and covering the semiconductor element, and a heat radiation plate covered by the resin mold, exposed from one surface of the resin mold, insulated from the semiconductor element, and radiating heat generated in the semiconductor element; and a cooler disposed on a surface of the semiconductor module where the heat radiation plate is exposed, providing a refrigerant passage, and promoting radiation of heat from the heat radiation plate by flowing a refrigerant through the refrigerant passage. The heat radiation plate includes fins provided by pulling up a surface of the radiator plate. The fins have a tapered shape with an elliptical arc shape curved from a base to a tip.

In the semiconductor device configured as above, the fins are formed by pulling up and formed into an elliptical arc shape. Because the fins are of an elliptical arc shape, a flow of the refrigerant in a height direction of the fins can be developed. Owing to the configuration as above, the semiconductor device becomes capable of having a flat plane as the surface before the fins are formed by pulling up and cooling the semiconductor module at higher cooling efficiency.

BRIEF DESCRIPTION OF DRAWINGS

The above and other objects, features and advantages of the present disclosure will become more apparent from the following detailed description made with reference to the accompanying drawings. In the drawings:

[Fig. 1] Fig. 1 is a circuit diagram of a three-phase inverter circuit formed by a semiconductor module provided to a semiconductor device according to a first embodiment of the present disclosure;
[Fig. 2] Fig. 2 is a perspective view of the semiconductor module;
[Fig. 3] Fig. 3 is a perspective view showing the semiconductor module sandwiched by coolers from both surfaces;
[Fig. 4] Fig. 4 is an exploded perspective view showing components forming the semiconductor module;
[Fig. 5] Fig. 5 is a top layout view of the semiconductor module;
[Fig. 6] Fig. 6 is a perspective view of a multi-layer wiring bus bar;
[Fig. 7] Fig. 7 is a sectional view of the semiconductor device;
[Fig. 8] Fig. 8 is an exploded view of the semiconductor device;
[Fig. 9] Fig. 9 is a top view of the semiconductor module;
[Fig. 10] Fig. 10 is a sectional view of and around a fin portion;
[Fig. 11] Fig. 11 is a top view of the fin portions;
[Fig. 12] Fig. 12 is a chart showing a result of a simulation on a relationship between a clearance above the fin portions and a bypass flow rate proportion;
[Fig. 13A] Fig. 13A a top layout view of a model used in the simulation of Fig. 12;
[Fig. 13B] Fig. 13B is a sectional view of the model used in the simulation of Fig. 12;
[Fig. 14] Fig. 14 is a chart showing a relationship of a deformation amount with respect to an applied load;
[Fig. 15A] Fig. 15A is a sectional view of a model used in a simulation of Fig. 14;

[Fig. 15B] Fig. 15B is a sectional view of another model used in the simulation of Fig. 14;

[Fig. 16] Fig. 16 is a sectional view of a model of an elliptical arc fin;

[Fig. 17] Fig. 17 is a chart showing a relationship between a coefficient k and a ratio of thermal conductivity to a pressure loss rate;

[Fig. 18] Fig. 18 is a chart showing a relationship between a fluid vector and a ratio of thermal conductivity to a pressure loss rate;

[Fig. 19] Fig. 19 is a chart showing a relationship between a normalized pressure loss and normalized thermal conductivity;

[Fig. 20] Fig. 20 is a sectional view of a model used to compare cooling performance;

[Fig. 21] Fig. 21 is a flow velocity counter figure in a recess portion;

[Fig. 22] Fig. 22 is a chart showing a result when cooling efficiency is checked for respective structures in reference to a straight fin;

[Fig. 23] Fig. 23 is a view showing a relationship between a refrigerant flow direction and a skiving direction of the fin portions;

[Fig. 24] Fig. 24 is a sectional view of a fin portion according to a second embodiment of the present disclosure;

[Fig. 25A] Fig. 25A is a side view of a skiving tool;

[Fig. 25B] Fig. 25B is a front view of the skiving tool;

[Fig. 25C] Fig. 25C is a sectional view of a skived fin portion formed by the skiving tool;

[Fig. 26] Fig. 26 is a top view of a fin portion according to a third embodiment of the present disclosure;

[Fig. 27] Fig. 27 is a front view of a skiving tool used to form the fin portion shown in Fig. 26;

[Fig. 28] Fig. 28 is a top view of a fin portion according to a modification of the third embodiment;

[Fig. 29] Fig. 29 is a front view of a skiving tool used to form the fin portion shown in Fig. 28;

[Fig. 30] Fig. 30 is a perspective view of a semiconductor device according to a fourth embodiment of the present disclosure;

[Fig. 31] Fig. 31 is an exploded view of the semiconductor device shown in Fig. 30;

[Fig. 32] Fig. 32 is a sectional view of respective fin portions of two semiconductor modules; and

[Fig. 33] Fig. 33 is a perspective view of an inverter unit as an example of application of a semiconductor device including multiple stacked semiconductor modules.

EMBODIMENTS FOR CARRYING OUT INVENTION

Hereinafter, embodiments of the present disclosure will be described according to the drawings. A description will be given by labelling same or equivalent portions with same reference numerals in respective embodiments below.

First Embodiment

A first embodiment of the present disclosure will be described. The present embodiment will describe a semiconductor device having a semiconductor module provided with a three-phase inverter circuit driving, for example, a three-phase AC motor, as an example of application of a semiconductor device having a semiconductor module according to one embodiment of the present disclosure.

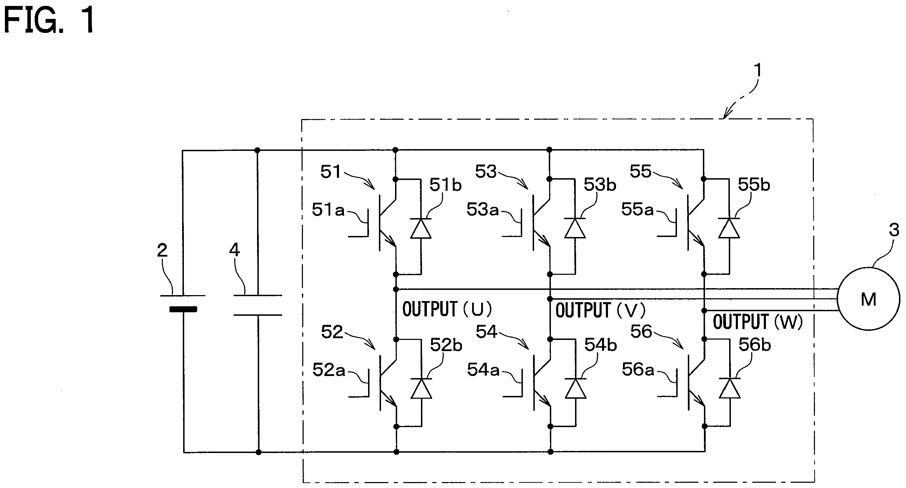

A configuration of a three-phase inverter circuit 1 provided to the semiconductor module will be described first with reference to Fig. 1. As is shown in Fig. 1, the three-inverter circuit 1 drives a load 3, such as a three-phase AC motor, on a DC power supply (external power supply) 2. A smoothing capacitor 4 is connected in parallel to the three-phase inverter circuit 1 to generate a steady power-supply voltage by reducing a ripple caused by a switching action and restricting an influence of noise.

The three-phase inverter circuit 1 includes three phases of serially-connected upper and lower arms 51 through 56 which are connected in parallel phase by phase, and applies potential at intermediate points between the upper arms 51, 53, and 55 and the lower arms 52, 54 and 56, respectively, to phases U, V, and W of the three-phase AC motor as the load 3 phase by phase. More specifically, the upper and lower arms 51 through 56 include semiconductor switching elements 51a through 56a, respectively, such as IGBTs and MOSFETs functioning as heater elements, and rectifier elements (one-way conductive elements) 51b through 56b, respectively, such as FWDs, to flow back a current. BY controlling ON and OFF states of the semiconductor switching elements 51a through 56a of the upper and lower arms 51 through 56, respectively, phase by phase, an AC current of three phases in different cycles is supplied to the three-phase AC motor. The three-phase AC motor can be thus driven.

In the present embodiment, semiconductor chips provided with the semiconductor switching elements 51a through 51f and the rectifier elements 51b through 56b respectively forming the six upper and lower arms 51 through 56 included in the three-phase inverter circuit 1 are integrated into a module. That is, the three-phase inverter circuit 1 is formed as a 6-in-1 semiconductor module having six arms combined into one unit.

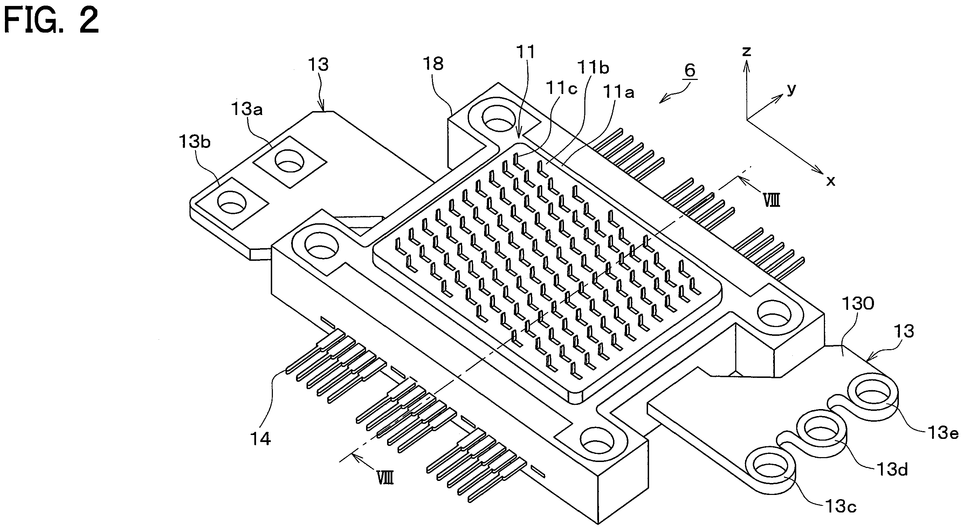

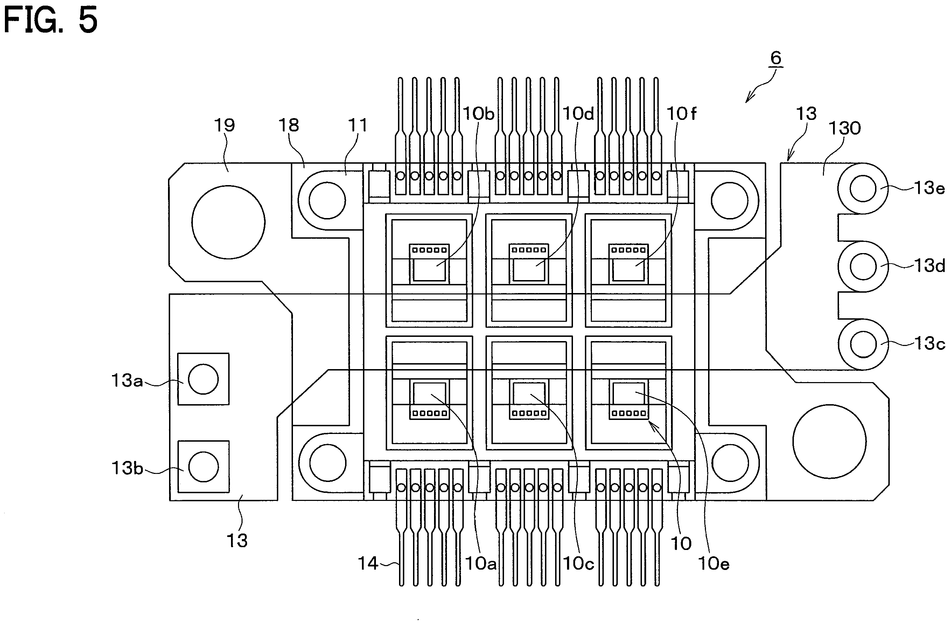

The following will describe a detailed structure of a semiconductor device having a semiconductor module provided with the three-phase inverter circuit 1 of the circuit configuration as described above with reference to Fig. 2 through Fig. 8.

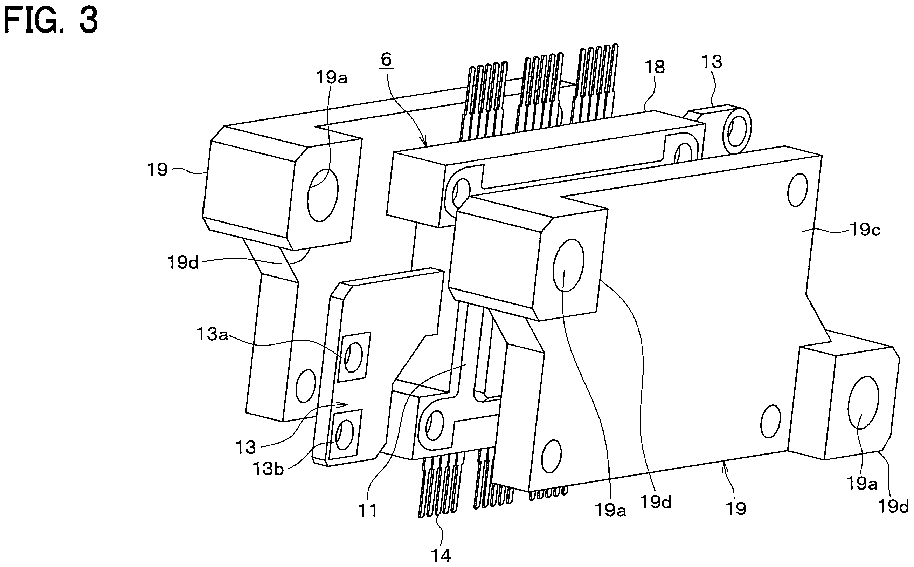

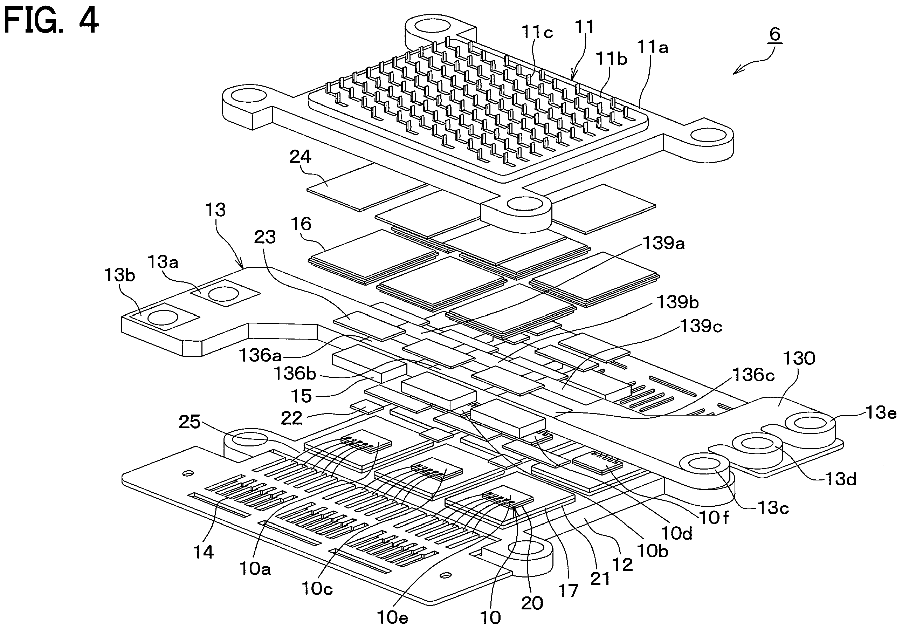

As is shown in Fig. 4, a semiconductor module 6 shown in Fig. 2 includes semiconductor chips 10, upper and lower radiator plates 11 and 12, a multi-layer wiring bus bar 13 integrally including respective terminals and wirings, control terminals 14, element relay electrodes 15, plates 16 and 17, and so on. One semiconductor chip 10, one control terminal 14, one element relay electrode 15, one plate 16, one plate 17, and so on form a component block of one arm, and the semiconductor module 6 includes six component blocks. The six component blocks together with the multi-layer bus bar 13 are sandwiched by the upper and lower radiator plates 11 and 12, and covered with a resin mold portion 18 as is shown in Fig. 2. The semiconductor module 6 is thus formed as a plate-shaped member having a predetermined thickness as is shown in Fig. 2. As is shown in Fig. 3, the semiconductor module 6 is sandwiched by coolers 19 from both sides in a thickness direction and used to drive the load 3 while radiating heat. At two diagonally opposing corners, the cooler 19 is provided with through-holes 19a and passage forming portions 19d to form a refrigerant passage by connecting the respective through-holes 10a. The semiconductor module 6 is thus cooled by the coolers 19. Hence, the semiconductor module 6 in use can be cooled efficiently.

The following will describe a detailed structure of the semiconductor device having the semiconductor module 6. The component blocks of six arms covered with the resin mold portion 18 have substantially a same fundamental structure except for a minor difference in detail. Respective components forming the fundamental structure of the component blocks covered with the resin mold portion 18 will be described first.

The semiconductor chips 10 shown in Fig. 4 are six chips 10a through 10f. The respective chips 10a through 10f have front surfaces and back surfaces, on which the semiconductor switching elements 51a through 56a and the rectifier elements 51b through 56b forming the upper arms 51, 53, and 55 and the lower arms 52, 54, and 56 are provided. For example, a base substrate of the semiconductor chip 10 is a Si, SiC, or GaN semiconductor substrate. In the present embodiment, the semiconductor switching elements 51a through 56a and the rectifier elements 51b through 56b provided to the semiconductor chips 10 are vertical elements which pass a current in a substrate vertical direction. Electrodes (pads) are provided to a front surface side and a back surface side of the semiconductor chip 10 and an electrical connection is established via the electrodes. In the present embodiment, the back surface side of the semiconductor chip 10 is electrically and physically connected to a front surface side of the lower plate 17 via a bonding material 20 made of a high thermal conductive material, such as solder and an Ag sintered material. A back surface side of the lower plate 17 is bonded to the lower radiator plate 12 via a bonding material 21 made of a high thermal conductive material, such as solder and an Ag sintered material.

The front surface side of the semiconductor chip 10 is connected to the element relay electrode 15 made of Cu, Al, Fe or the like as a base material via a bonding material 22 made of a high thermal conductive material, such as solder and an Ag sintered material. The element relay electrode 15 is electrically and physically connected to a back surface side of the upper plate 16 via a bonding material 23 made of a high thermal conductive material, such as solder and an Ag sintered material. A front surface side of the upper plate 16 is bonded to the upper radiator plate 11 via a bonding material 24 made of a high thermal conductive material, such as solder and an Ag sintered material.

According to the structure as above, the respective semiconductor chips 10 are sandwiched by the upper and lower radiator plates 11 and 12.

In the present embodiment, elements forming one arm among the semiconductor switching elements 51a through 56a and the rectifier elements 51b through 56b forming the arms 51 through 56, respectively, are provided to the semiconductor chip 10 as a single chip. However, the description above is a mere example. All of the semiconductor switching elements 51a through 56a and the rectifier element 51b through 56b forming the arms 51 through 56, respectively, may be provided to separate chips.

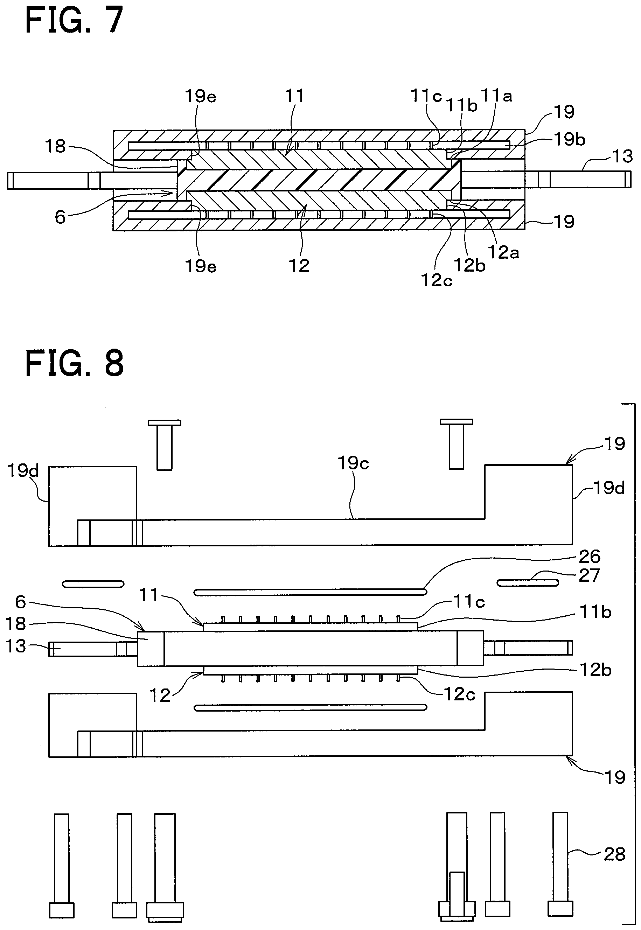

The upper and lower radiator plates 11 and 12 correspond to heat sinks, and formed of, for example, a high thermal conductive member chiefly made of Cu, Al, Fe or the like. One surface side is faced to the semiconductor chips 10 and the other surface side is exposed from the resin mold portion 18 as is shown in Fig. 2. The upper and lower radiator plates 11 and 12 are of a stepped shape. That is, the upper and lower radiator plates 11 and 12 have outer edge portions 11a and 12a (see Fig. 7) and inner portions 11b and 12b (see Fig. 7) on an inner side of the outer edge portions 11a and 12a, respectively, and the inner portions 11b and 12b protrude, respectively, from the outer edge portions 11a and 12a by a predetermined amount. More specifically, the outer edge portions 11a and 12a are flush with surfaces of the resin mold portion 18 surrounding the respective outer edge portions 11a and 12a, whereas the inner portions 11b and 12b protrude from the resin mold portion 18 by a predetermined distance. The inner portions 11b and 12b are provided, respectively, with multiple fin portions 11c and 12c formed by skiving top-layer portions of the inner portions 11b and 12b, respectively, with a skiving tool. A detailed structure of the multiple fin portions 11c and 12c will be described below. In Fig. 7, respective components provided inside the resin mold portion 18 are omitted.

The upper and lower radiator plates 11 and 12 are insulated from the semiconductor chips 10 by the upper and lower plates 16 and 17 made of an insulating material in part. It should be noted, however, that heat from the semiconductor chips 10 is transmitted to the upper and lower radiator plates 11 and 12 at high thermal conductivity via the upper and lower plates 16 and 17, the element relay electrodes 15, and so on made of a high thermal conductive material. Radiation takes place on the front surface side of the upper radiator plate 11 and the back surface side of the lower radiator plate 12, that is, on the surfaces where the fin portions 11c and 12c are provided.

The multi-layer wiring bus bar 13 is a portion forming various wirings and various terminals in the semiconductor module 6 of the present embodiment. In the present embodiment, the multi-layer wiring bus bar 13 is formed of a plate bar member, and disposed to pass through a space between the semiconductor chips 10 forming the upper arms 51, 53, and 55 of the respective phases and the semiconductor chips 10 forming the lower arms 52, 54, and 56. For example, the multi-layer wiring bus bar 13 is provided with positive-electrode-side wirings connecting the upper arms 51, 53, and 55 and a plus terminal of the DC power supply 2, negative-electrode-side wirings connecting the lower arms 52, 54, and 56 and a minus terminal of the DC power supply 2, and output wirings connecting the respective arms 51 through 56 and the load 3. The multi-layer wiring bus bar 13 is also provided with various connection terminals 13a through 13e connecting the respective wirings to the DC power supply 2 and the load 3.

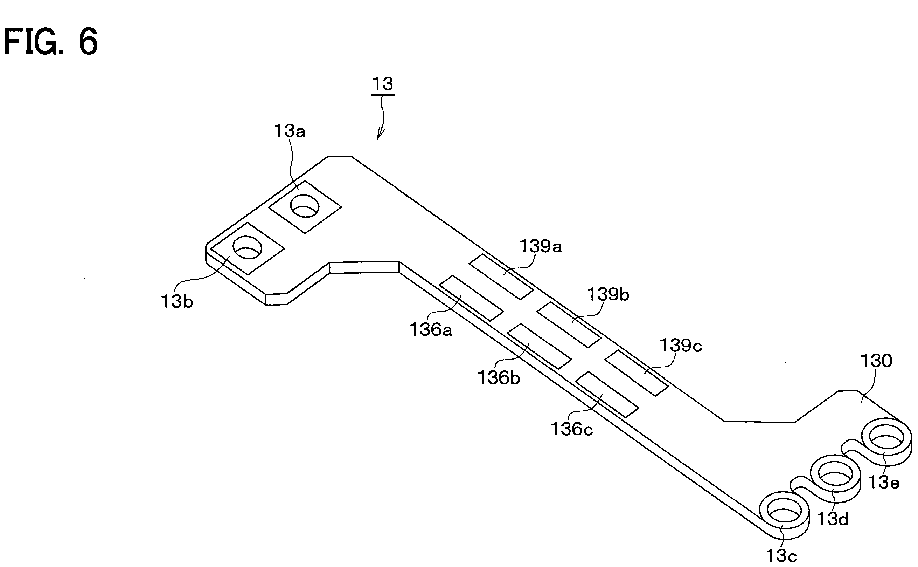

More specifically, as is shown in Fig. 6, the multi-layer wiring bus bar 13 is formed of a plate bar member having a longitudinal direction in one direction, and as is shown in Fig. 2, one end and the other end are respectively exposed from two opposing sides of the resin mold portion 18 of substantially a square shape.

As is shown in Fig. 6, a positive-electrode terminal 13a connecting the upper arms 51, 53, and 55 to the plus terminal of the DC power supply 2, and a negative-electrode terminal 13b connecting the lower arms 52, 54, and 56 to the minus terminal of the DC power supply 2 are provided to one end of the multi-layer wiring bus bar 13. A U-terminal 13c, a V-terminal 13d, and a W-terminal 13e corresponding to output terminals connecting intermediate potential points of the upper and lower arms 51 through 56 of the respective phases U, V, and W to the load 3 are provided to the other end of the multi-layer wiring bus bar 13. As is shown in Fig. 2, the positive-electrode terminal 13a, the negative-electrode terminal 13b, the U-terminal 13c, the V-terminal 13d, and the W-terminal 13e are exposed from the resin mold portion 18. Owing to the configuration as above, the semiconductor module 6 is electrically connected to the DC power supply 2 and the smoothing capacitor 4 via the positive-electrode terminal 13a and the negative-electrode terminal 13b. Also, the semiconductor module 6 is electrically connected to the phases U, V, and W of the three-phase AC motor as the load 3 via the U-terminal 13c, the V-terminal 13d, and the W-terminal 13e, respectively.

The multi-layer wiring bus bar 13 has a multi-layer wiring structure in which patterned conductive layers and insulating layers are stacked, and forms a circuit wiring electrically interconnecting the respective portions of the three-phase inverter circuit 1 shown in Fig. 1. Pads 136a through 136c and 139a through 139c provided to the multi-layer wiring bus bar 13 are electrically connected to predetermined portions of the corresponding semiconductor chips 10a through 10f. Although an illustration is omitted herein, multiple pads electrically connected to predetermined portions of the corresponding semiconductor chips 10a through 10f are also provided to the multi-layer wiring bus bar 13 on a surface opposite to the surface where the pads 136a through 136c and 139a through 139c are provided. A wiring structure of the three-phase inverter circuit 1 is formed by electrically connecting an internal wiring provided to the multi-layer wiring bus bar 13 to the respective pads 136a through 136c and 139a through 139c and thereby electrically connecting the internal wiring to the respective terminals 13a through 13e. The internal wiring is covered with an insulating film 130 while the respective pads 136a through 136c and 139a through 139c and the respective terminals 13a through 13e are exposed from the insulating film 130.

The control terminals 14 are signal line terminals forming various signal lines, such as gate wirings of the semiconductor switching elements 51a through 56a. For example, the control terminals 14 are electrically connected to electrodes connected to gates of the semiconductor switching elements 51a through 56a provided on the front surface side of the semiconductor chips 10 via bonding wires 25 (see Fig. 4) made of Au or the like. As is shown in Fig. 2, ends of the control terminals 14 on an opposite side to the semiconductor chips 10 are exposed from the resin mold portion 18, and establish an external connection via the exposed portions. Fig. 4 shows the control terminals 14 integrated in the form of a lead frame, which is also integrated with the lower radiator plate 12. However, the control terminals 14 are divided into individual signal lines in a final product.

The element relay electrode 15 is a member electrically connected to the upper plate 16 across one surface on the side of the semiconductor chip 10 while being electrically connected to the electrode on the surface of the semiconductor chip 10. The element relay electrode 15 is provided to produce a clearance large enough to dispose the bonding wire 25 between the semiconductor chip 10 and the upper plate 16. The element relay electrode 15 is made of, for example, a high thermal conductive member chiefly made of Cu or the like.

The upper plate 16 provides insulation between the semiconductor chip 10 and the upper radiator plate 11 by using one surface on the side of the semiconductor chip 10 while being electrically connected to the electrode on the front surface of the semiconductor chip 10 via the element relay electrode 15. Likewise, the lower plate 17 provides insulation between the semiconductor chip 10 and the lower radiator plate 12 by using one surface on the side of the semiconductor chip 10 while being electrically connected to the electrode on the back surface of the semiconductor chip 10.

The surfaces of the upper and lower plates 16 and 17 on the side of the semiconductor chip 10 are formed of a high thermal conductive member made of Cu, Al or the like as a base material not only to establish an electrical connection but also to increase thermal conductive performance. Layers of the upper and lower plates 16 and 17 located on an opposite side to the semiconductor chip 10 are made of, for example, an inorganic or organic insulating material to have higher thermal conductive performance than the surfaces of the semiconductor chips 16 and 17 on the side of the semiconductor chip 10 while providing insulation. The upper and lower plates 16 and 17 may be formed by laminating conductor plates made of Cu as a base material to both surfaces of a ceramics insulator, for example, a Si3N4, AIN, or Al2O3 insulator. Alternatively, the upper and lower plates 16 and 17 may be formed by laminating a Cu plate laminated with an insulating sheet and an adhesive sheet furnished with an insulation bonding function to a die bond plate formed of a conductor member made of Cu or the like.

Owing to the configuration as above, the upper plates 16 are connected to the electrodes on the front surfaces of the semiconductor switching elements 51a through 56a (for example, sources of MOSFETs or emitters of IGBTs) and first electrodes of the rectifier elements 51b through 56b (for example, anodes of FWDs). The upper plates 16 are also electrically connected to the pads 136a through 136c and 139a through 139c provided to the multi-layer wiring bus bar 13 in a one-to-one correspondence. Likewise, the lower plates 17 are connected to the electrodes on the back surfaces of the semiconductor switching elements 51a through 56a (for example, drains of MOSFETs or collectors of IGBTs) and second electrodes of the rectifier elements 51b through 56b (for example, cathodes of FWDs). The lower plates 17 are also electrically connected to the pads (not shown) provided to the back surface side of the multi-layer wiring bus bar 13 in a one-to-one correspondence, too. Hence, the upper and lower plates 16 and 17 form a part of the positive-electrode wirings, the negative-electrode wirings, and the output wirings of the respective arms 51 through 56.

As has been described above, the front surface side of the upper radiator plate 11 and the back surface side of the lower radiator plate 12, that is, the surfaces opposite to the surfaces where the semiconductor chips 10 are disposed are exposed from the resin mold portion 18, and radiation takes place at the exposed portions. As is shown in Fig. 3, the coolers 19 are disposed on the radiation surface sides. As is shown in Fig. 7, hollow portions defined inside the coolers 19 form flow passages 19b, and the refrigerant is forced to flow the flow passages 19b. Hence, the radiation surfaces of the upper and lower radiator plates 11 and 12 come into contact with the refrigerant. However, insulation is provided between the semiconductor chips 10 and the upper and lower radiator plates 11 and 12 by the upper and lower plates 16 and 17, respectively. Hence, a current is prevented from leaking to an outside through the upper and lower radiator plates 11 and 12.

The resin mold portion 18 is encapsulation resin formed by placing the respective components described above in a forming die and filling the forming die with resin, and formed in, for example, a square plate shape. The resin mold portion 18 is made of insulating resin having lower linear expansion coefficient and Young's modulus than the conductor portions, such as the upper and lower radiator plates 11 and 12. The resin mold portion 18 may be chiefly made of organic resin, for example, epoxy or silicone. From the resin mold portion 18, the tip ends of the control terminals 14 and both ends of the multi-layer wiring bus bar 13 are exposed from respective sides forming the square plate shape to establish an external electric connection. More specifically, the control terminals 14 of the upper arms 51, 53, and 55 and the control terminals 14 of the lower arms 52, 54, and 56 are exposed, respectively, from two opposing sides of the resin mold portion 18 of a square plate shape, that is, to opposite directions with the resin mold portion 18 in between. The both ends of the multi-layer wiring bus bar 13 are exposed from the other opposing two sides of the resin mold portion 18 of a square plate shape, that is, to opposite directions with the resin mold portion 18 in between. The upper radiator plate 11 and the lower radiator plate 12 are exposed, respectively, from main and back surfaces of a square plate shape. The structure as above enables radiation to take place in a satisfactory manner.

More specifically, the respective portions described above are mounted to the front surface side of the lower radiator plate 12 in the form of a lead frame integrally provided with the control terminals 14. After the semiconductor chips 10 and the control terminals 14 are electrically connected with the bonding wires 25, the upper radiator plate 11 and so on are mounted on the lower radiator plate 12. The resin mold portion 18 is molded by placing the components mounted in the manner as above in the forming die and by filling the forming die with resin. The semiconductor chips 10 and so on are protected by covering the components with the resin mold portion 18 except for portions where the control terminal 14 and the multi-layer bus bar 13 are exposed in addition to the surfaces of the upper and lower radiator plates 11 and 12.

The coolers 19 promote radiation from the semiconductor module 6 by forming the refrigerant passages 19b inside and by forcing the refrigerant to flow. The coolers 19 are disposed to both radiation surfaces of the semiconductor module 6 where the upper and lower radiator plates 11 and 12 are disposed. The coolers 19 and the semiconductor module 6 are stacked to sandwich the semiconductor module 6 by the coolers 19. As is shown in Fig. 8, the two coolers 19 and the semiconductor module 6 are fastened with bolts 28 and formed into one unit to sandwich the semiconductor module 6 by the coolers 19.

To be more concrete, as is shown in Fig. 3, the cooler 19 includes a hollow plate portion 19c of substantially a rectangular shape when viewed from an opposite side to the semiconductor module 6, and the passage forming portions 19d provided with the through-holes 19a. A hollow portion defined inside the hollow plate portion 19c forms the refrigerant passage 10b. The refrigerant introduced into one through-hole 19a is discharged from the other through-hole 19a after passing through the refrigerant passage 19b.

As is shown in Fig. 7, openings 19e connected to the refrigerant passages 19b are provided to the hollow plate portions 19c in respective surfaces on the side of the semiconductor module 6. The inner portions 11b and 12b and the fin portions 11c and 12c are disposed inside the openings 19e. An outer edge shape of the inner portions 11b and 12b conforms to a shape of the openings 19e, and the coolers 19 are combined to the semiconductor module 6 by fitting the inner portions 11b and 12b into the respective openings 19e.

One surface of the hollow plate portion 19c on the side of the semiconductor module 6 has a predetermined thickness comparable to an amount of protrusion of the inner portions 11b and 12b from the outer edge portions 11a and 12a, respectively.

As Is shown in Fig. 8, seal members 26 enclosing the openings 19e are disposed between the respective coolers 19 and the semiconductor module 6. Hence, spaces between the coolers 19 and the semiconductor module 6 are sealed by the sealing members 26 to prevent leakage of the refrigerant.

As will be described below, a dimension of the refrigerant passage 19b provided to the cooler 19 in the stacking direction of the semiconductor module 6 and the coolers 19 is set to be less than a height of the fin portions 11c and 12c. The fin portions 11c and 12c are tapered toward the tip ends and therefore easy to deform. Hence, when the semiconductor module 6 and the coolers 19 are combined together, the tip ends of the fin portions 11c and 12c make contact with the inner wall surfaces of the coolers 19, which define the refrigerant passages 19b, and undergo deformation upon contact with the inner wall surfaces. The seal portions 26 are thus disposed between the coolers 19 and the semiconductor module 6 without any clearance and enabled to exert a sealing function in a reliable manner.

As is shown in Fig. 3, the passage forming portion 19d is of a rectangular shape and the through-hole 19a is provided at a center position. The passage forming portions 19d of the adjacent coolers 19 adhere closely to each other via the sealing members 27 enclosing the through-holes 19a to connect the through-holes 19a of the adjacent coolers 19. The through-hole 19a communicates with the refrigerant passage 19b. Hence, the refrigerant introduced into the through-holes 19a in the passage forming portions 19d adhered closely to each other at one corner is discharged from the through-holes 19a in the passage forming portions 19d adhered closely to each other at the diagonally opposing corner after passing through the refrigerant passages 10b.

As has been described above, a dimension of the refrigerant passage 19b provided to the cooler 19 in the stacking direction of the semiconductor module 6 and the coolers 19 is set to be less than a height of the fin portions 11c and 12c. However, the fin portions 11c and 12c are easy to deform at the tip ends. The seal members 26 are thus disposed between the adjacent passage forming portions 19d without any clearance and enabled to exert the sealing function in a reliable manner.

The through-holes 19a and the passage forming portions 19d are disposed at two corners at a diagonal position of substantially a rectangular shape when the cooler 19 is viewed from an opposite side to the semiconductor module 6. More specifically, the through-holes 19a and the passage forming portions 19d are disposed in such a manner that the end of the multi-layer bus bar 13 where the positive- and negative-electrode terminals 13a and 13b are provided and the end where the U-through W-terminals 13c through 13e are provided protrude from other two corners at a diagonal position of the coolers 19 of substantially a rectangular shape. The through-holes 19a are provided at positions displaced from the respective terminals 13a through 13e. Hence, the respective terminals 13a through 13e can be electrically connected to external wirings without being hidden by the through-holes 19a and the passage forming portions 19d of the coolers 19.

The above has described the structure of the semiconductor device having the semiconductor module 6 of the present embodiment. A detailed structure of the multiple fin portions 11c and 12c provided, respectively, to the radiator plates 11 and 12 will now be described with reference to Fig. 2, Fig. 7, and Fig. 9 through Fig. 11. The following will chiefly describe the multiple fin portions 11c, and the multiple fin portions 12c are formed in a same manner as the multiple fin portions 11c.

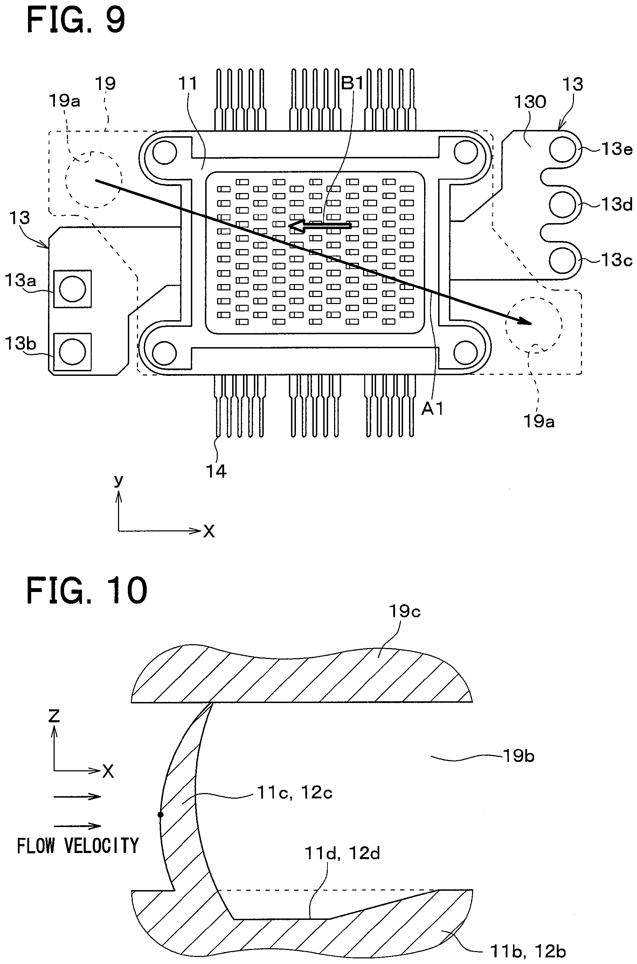

As are shown in Fig. 2 and Fig. 9, the inner portion 11b is of a rectangular shape having long sides in a same direction as the longitudinal direction of the multi-layer wiring bus bar 13 and short sides in a direction perpendicular to the longitudinal direction. As is shown in Fig. 2, let a long side direction of the inner portion 11b be an x direction, a short side direction be a y direction, and a normal direction to the inner portion 11b be a z direction. Then, the multiple fin portions 11c are aligned in a predetermined layout in the x direction and the y direction. The multiple fin portions 11c are formed one by one by slicing and folding up, that is, by skiving a surface of the inner portion 11b in a z-axis direction with a skiving tool.

In the present embodiment, the multiple fin portions 11c are arranged by aligning a predetermined number of the multiple fin portion 11c at regular intervals in a row in the y direction and by aligning two or more same rows at a regular interval in the x direction. According to the layout herein, positions of the fin portions 11c in adjacent rows are displaced in the y direction, and the fin portions 11c in one row are disposed at intermediate positions of the fin portions 11c in the adjacent row in the y direction. In short, the multiple fin portions 11c are aligned in a zigzag layout.

Meanwhile, as is shown in Fig. 9, a refrigerant flow direction in the cooler 19 is a direction heading from the through-hole 19a on the refrigerant introducing side to the through-hole 19a on the refrigerant discharging side, which is indicated by an arrow A1 in Fig. 9. Hence, the multiple fin portions 11c in the zigzag layout are aligned along the refrigerant flow direction. The phrase, "the multiple fin portions 11c are aligned along the refrigerant flow direction", referred to herein means that the multiple fin portions 11c are not necessarily parallel to the refrigerant flow direction and an angle may be produced between the alignment direction and the refrigerant flow direction. However, it is preferable to align the multiple fin portions 11c parallel to a straight line (indicated by the arrow A1 in Fig. 9) passing center positions of the both through-holes 19a, because a flow of the refrigerant is not blocked and a pressure loss is lessened.

The multiple fin portions 11c are formed one by one by skiving the surface of the inner portions 11b along the y direction. Hence, a skiving direction (indicated by an arrow B1 In Fig. 9) of the multiple fin portions 11c produces an acute angle greater than 0° and not greater than 45° with respect to the refrigerant flow direction (indicated by the arrow A1 in Fig. 9).

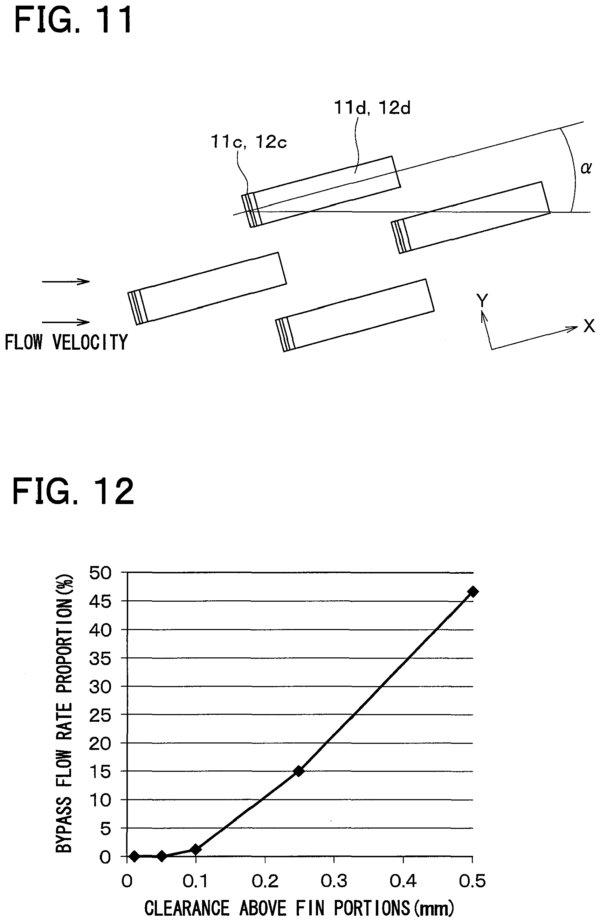

Each of the multiple fin portions 11c is of an elliptical arc shape curved from base to tip. More specifically, as is shown in Fig. 10, the fin portion 11c is of an elliptical arc shape in cross section taken parallel to the skiving direction and also parallel to a normal direction to the surface of the inner portion 11b. The fin portion 11c is tapered toward the tip end. Hence, the tip end is easier to deform than a base portion. In the present embodiment, as is shown in Fig. 11, the inner portion 11b is skived in a constant width, and as is shown in Fig. 10, the inner portion 11b is skived gradually deeper to a skiving intermediate position and skived at a constant depth after the skiving intermediate position. Hence, the fin portion 11c has a constant thickness in a direction same as the skiving direction from the base to the skiving intermediation position and gradually becomes thinner from the intermediate position to the tip end.

In the present embodiment, a surface of the elliptical arc fin portion 11c formed of the surface of the inner portion 11b is a protruding surface and a surface on a skived side is a recessed surface. Hence, the fin portion 11c receives a flow velocity of the refrigerant on the protruding surface side. The surface of the inner portion 11b is skived in such a manner that a recess portion 11d left after the fin portion 11c is formed by skiving is located downstream of the fin portion 11c in a flow of the refrigerant.

A dimension of the fin portion 11c may be arbitrary. However, in order to restrict deterioration of a flow of the refrigerant and a development of a complex turbulence due to the recess portion 11d left after the skiving as will be described below, a thickness as an x-direction dimension and a width as a y-direction dimension are set to 1 mm or less, and a height as a z-direction dimension is set to less than 10 mm. The height of the fin portion 11c is greater than the dimension of the refrigerant passage 19b provided to the cooler 19 in the stacking direction of the semiconductor module 6 and the coolers 19. Preferably, the height of the fin portion 11c is set to make a difference between the height of the fin portion 11c and the dimension of the refrigerant passage 19b to be less than a maximum amount of deformation of the fin portion 11c.

Effects obtained by the semiconductor device having the multiple fin portions 11c configured as above will now be described with reference to Fig. 12 through Fig. 23.

(1) In the semiconductor device of the present embodiment, the multiple fin portions 11c and 12c are provided to the upper and lower radiator plates 11 and 12, respectively, by skiving the surfaces of the upper and lower radiator plates 11 and 12, respectively. Hence, the surfaces of the upper and lower radiator plates 11 and 12 are flat planes before the multiple fin portions 11c and 12c are formed by skiving. Consequently, a bonding state of element portions provided inside can be inspected by a scanning acoustic tomograph or the like.

(2) In the semiconductor device of the present embodiment, the thickness of one surface of the hollow plate portion 19c of the cooler 19 on the side of the semiconductor module 6 is made comparable to an amount of protrusion of the inner portions 11b and 12b.

Hence, the fin portions 11c and 12c in full height are exposed in the refrigerant flow passages 19b at a location where the refrigerant flows easily. For example, the inner portions 11b and 12b may be flush with the outer edge portions 11a and 12a, respectively, and with the resin mold portion 18. In such a case, however, the bases of the fin portions 11c and 12c are hidden inside recesses formed due to a thickness of the coolers 19. Hence, the bases are located in the refrigerant passage 19b at a position where the refrigerant does not flow easily. By contrast, in the present embodiment, the inner portions 11b and 12b protrude from the outer edge portions 11a and 12a, respectively, and the resin mold portion 18. Hence, the bases of the fin portions 11c and 12c are not hidden due to the thickness of the coolers 19, and the fin portions 11c and 12c can be located at a position where the refrigerant flows easily to the bases. Radiation efficiency can be thus enhanced, which can in turn reduce the height of the fin portions 11c and 12c. Consequently, the semiconductor device can be reduced in size.

(3) In the semiconductor device of the present embodiment, a dimension of the refrigerant passage 19b provided to the cooler 19 in the stacking direction of the semiconductor module 6 and the coolers 19 is set to be less than the height of the fin portions 11c and 12c. Hence, the tip ends of the fin portions 11c and 12c make contact with the inner wall surfaces of the hollow plate portions 19c of the coolers 19 and no clearance is produced in between. Accordingly, formation of bypass passages can be prevented by preventing formation of clearances between the tip ends of the fin portions 11c and 12c and the hollow plate portions 19c. Consequently, a phenomenon that the refrigerant flows by bypassing the fin portions 11c and 12c can be prevented.

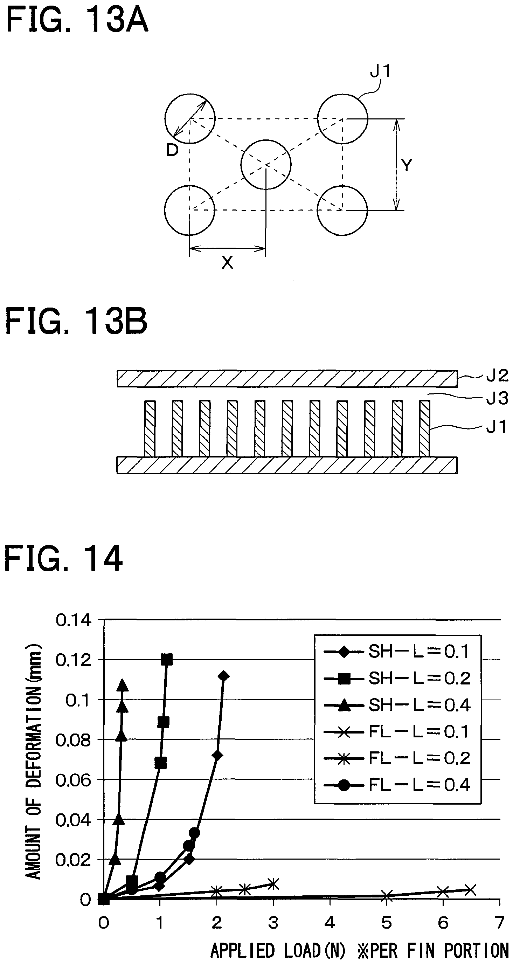

For example, a relationship between a width of a clearance above the fin portions, that is, a width of the bypass passage, and a flow rate in the bypass passage (hereinafter, referred to as the bypass flow rate) is checked by simulation, and a result of the simulation is set forth in Fig. 12. More specifically, a simulation model in which multiple straight fins J1 are aligned in a zigzag fashion as are shown Figs. 13A and 13B is used, and the bypass flow rate is checked by varying a clearance J3 between the straight fins J1 and a cooler J2. The simulation is performed under conditions that a diameter and a height hc of the straight fins J1 are D and 2 x D, respectively, a pitch between the straight fins J1 in adjacent rows in the x direction is 2 x D, and a pitch between the straight fins J1 in a same row in the y direction is also 2 x D. In addition, the refrigerant used is pure water at 60°C.

As is set forth in Fig. 12, the bypass flow rate accounts for as low as about 0 to 2% when the clearance J3 is 0.1 mm or less whereas a proportion of the bypass flow rate increases after the clearance J3 exceeds 0.1 mm and the bypass flow rate accounts for as high as 15% when the clearance J3 is 0.25 mm. A proportion of the bypass flow rate increases as the clearance J3 becomes larger.

As has been described, when the clearance J3 exceeds 0.1 mm, a proportion of the bypass flow rate increases markedly. In the configuration described above in the related art column that the tube portion provided with multiple straight fins is inserted into the cooling base, it is necessary to set a height of the straight fins by allowing a manufacturing tolerance and warping of fins to precisely insert the tube portion provided with the multiple straight fins into the cooling base. Hence, a clearance between tip ends of the straight fins and the cooling base becomes larger and the bypass flow rate is increased, in which case radiation efficiency deteriorates.

In the present embodiment, by contrast, the tip ends of the fin portions 11c and 12c make contact with the inner wall surfaces of the hollow plate portions 19c of the coolers 19 and no clearance is produced in between. Hence, formation of the bypass passages between the tip ends of the fin portions 11c and 12c and the hollow plate portions 19c can be prevented. Consequently, deterioration of radiation efficiency can be restricted.

(3) In the semiconductor device of the present embodiment, the fin portions 11c and 12c are tapered toward the tip ends. Hence, the fin portions 11c and 12c are easy to deform in the height direction. Accordingly, even when the dimension of the refrigerant passages 19b provided to the coolers 19 in the stacking direction of the semiconductor module 6 and the coolers 19 is set to be less than the height of the fin portions 11c and 12c, a dimensional difference can be absorbed by deformation of the fin portions 11c and 12c.

Clearances between the fin portions 11c and 12c and the hollow plate portions 19c may be reduced by making the height of the fin portions 11c and 12c closer to the dimension of the refrigerant passages 19b provided to the coolers 19 in the stacking direction of the semiconductor module 6 and the coolers 19. By setting the clearance to 0.1 mm or less, a proportion of the bypass flow rate can be reduced and hence deterioration of cooling efficiency can be restricted.

In order to eliminate the clearance, it is preferable to set the dimension of the refrigerant passages 19b provided to the coolers 19 in the stacking direction of the semiconductor module 6 and the coolers 19 to be less than the height of the fin portions 11c and 12c when a manufacturing tolerance and deformation are taken into consideration. When the dimensional relationship as above is adopted, however, it is preferable to configure in such a manner so as to absorb a dimensional difference between the refrigerant passages 19b and the fin portions 11c and 12c by making the fin portions 11c and 12c easy to deform with a small load.

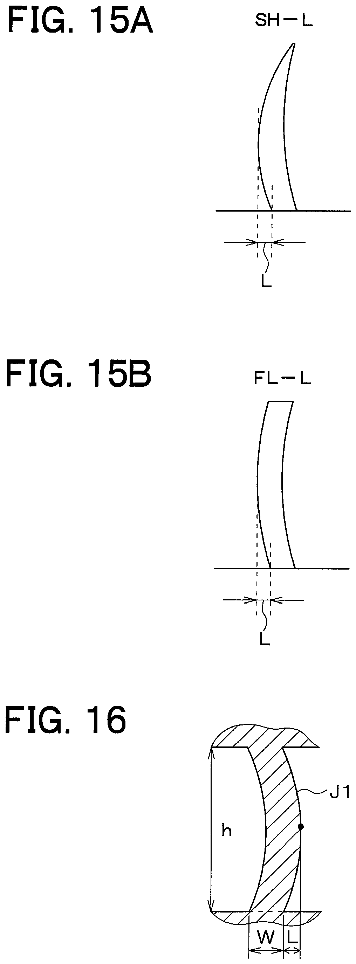

A relationship between a shape of the fin portions 11c and 12c and an amount of deformation by application of a load is evaluated. A result of the evaluation is set forth in Fig. 14. Herein, SH-L in Fig. 14 is an evaluation model as is shown in Fig. 15A in which the fin portions 11c and 12c are tapered in the same manner as in the present embodiment. Also, FH-L in Fig. 14 is an evaluation model as is shown in Fig. 15B in which the fin portions 11c and 12c have a constant diameter from base to tip as with straight fins. With the evaluation model of Fig. 15A, an amount of deformation is checked by varying an amount of protrusion, L, of an elliptical arc from the base to a most protruding point to 0.1, 0.2 and 0.4 mm. Likewise, with the evaluation model of Fig. 15B, an amount of deformation is checked by making the evaluation model into a round shape protruding at a midpoint while keeping the diameter constant and by varying an amount of protrusion, L, from the base to a most protruding point to 0.1, 0.2, and 0.4 mm.

In the case of the shape shown in Fig. 15B, the diameter is constant from base to tip. Hence, an amount of deformation in response to a load is small even when the evaluation model is formed into a round shape. When L = 0.1, which is close to a level of the straight fins, deformation hardly occurs in the z direction by application of a load. When a curvature of the round shape is increased, an amount of deformation in response to a load increases albeit only slightly. Such a slight increase in amount of deformation is attributed to a fact that distortion occurs intensively at the midpoint, which is an inflection point of the round shape, and the evaluation model withstands the load. Hence, an amount of deformation is small when a load is small.

Accordingly, when all of the fin portions 11c and 12c have a constant diameter, a large load is required to obtain an amount of deformation at a target value, which may possibly result in damage on the semiconductor device. It is therefore understood that the configuration as above requires clearances between the tip ends of the fin portions 11c and 12c and the inner wall surfaces of the hollow plate portions 19b. Consequently, the bypass passage is formed, which raises a problem that radiation efficiency deteriorates.

By contrast, when the fin portions 11c and 12c are tapered toward the tip ends as in the present embodiment, an amount of deformation is large even when a load is small. For example, when the target value of an amount of deformation of the fin portions 11c and 12c is set to 0.1 mm by taking a manufacturing tolerance and deformation into consideration, a required load is as follows: 2 [N] when L = 0.2 and 1 [N] when L = 0.4. Hence, a desired amount of deformation can be obtained at a small load by forming the fin portions 11c and 12c into an elliptical arc shape tapered toward a tip end. A desired amount of deformation can be obtained because the fin portions 11c and 12c are of an elliptical arc shape tapered to a tip end. That is, the fin portions 11c and 12c of a tapered shape have smaller sectional areas and therefore become easy to deform and an amount of deformation in the z direction increases when the fin portions 11c and 12c are formed into an elliptical arc shape. A deformation region shifts toward the tip end as an amount of protrusion, L, increases. Hence, deformation in the z direction can occur even when a load is small.

Distortion of the fin portions 11c and 12c deformed by 0.1 mm, which is the target value of an amount of deformation, is calculated, and it is confirmed that distortion when an amount of protrusion, L, is 0.2 mm, is sufficiently smaller than 0.2%. With distortion in such a level, deformation of the fin portions 11c and 12c is in a range of elastic deformation. Consequently, damage on the fin portions 11c and 12c can be restricted.

(4) In the semiconductor device of the present embodiment, the multiple fin portions 11c and 12c are of an elliptical arc shape and a skiving direction and a refrigerant flow direction produce an acute angle. Owing to such a configuration, cooling performance of the multiple fin portions 11c and 12c can be enhanced, which can in turn enhance radiation efficiency.

Even when the refrigerant passage is a steady channel, "thermal conductivity" and "a pressure loss", which are indexes of cooling performance, vary with a shape of the fin portions and a manner in which the refrigerant hits against the fin portions. Generally, a cooler with a high ratio of thermal conductivity to a pressure loss rate is said to have high cooling performance.

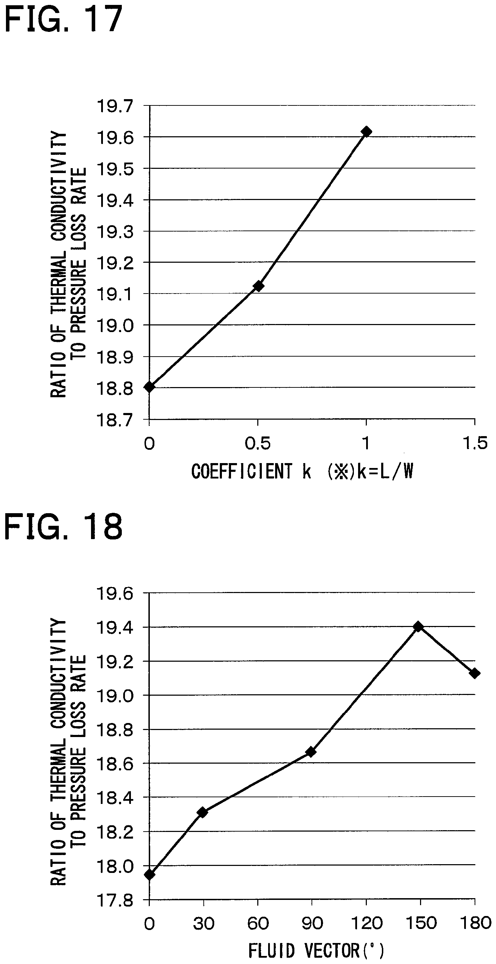

Hence, a thermo-fluid analysis is conducted on a model in which elliptical arc fins are aligned in a zigzag fashion. More specifically, a skiving width W (corresponding to a width of the fin portion) corresponding to a skiving depth as is shown in Fig. 16 is set as a reference, a height h of the fin portion J1 is set to 7 x W, and an amount of protrusion, L, is varied to 0, 0. 5 x W and 1.0 x W. A vector of the skiving direction and the refrigerant flow direction (that is, a direction of flow velocity), hereinafter, referred to as a fluid vector $\theta$, is set to 180°. That is, a simulation is performed by locating the protruding surface side of the fin portion J1 of an elliptical arc shape on an upstream side and the recessed surface side on a downstream side in a flow of the refrigerant. An influence of the elliptical arc shape on cooling performance is checked and a result as set forth in Fig. 17 is obtained. To be more specific, let k be a value found by dividing an amount of protrusion, L, by the width W of the fin portion J1 at the base (k = L/W), then a ratio of thermal conductivity to a pressure loss rate is checked by varying L. Lager k means a larger curvature of the elliptical arc. When k = 0, that is, L = 0, it is a case where the fin portion J1 is a straight pin.

As is set forth in Fig. 17, as k becomes larger, that is, as a curvature of the elliptical arc becomes larger, a pressure loss rate decreases. Consequently, a ratio of thermal conductivity to a pressure loss rate increases and cooling performance is enhanced. When a flow velocity contour at a midpoint of the channel is confirmed, a low flow velocity region becomes wider in the flow velocity behind the pin when L = 0 whereas the region becomes narrower when a value of L is increased. In the case of the straight pin, a fluid flowing in the x direction needs to move downstream by deviating in a direction of an x-y plane when the fluid hits against the fin portion. The fluid hardly flows around in the z direction because kinetic momenta are equal. On the contrary, when L > 0, that is, when the fin portion J1 is formed into an elliptical arc shape, the fin portion J1 starts to warp from the midpoint and a vacancy is present in an upper space. Accordingly, the fluid also flows around in the z direction due to the vacancy. Consequently, a flow velocity behind the fin portion J1 rises and hence the pressure loss rate can be reduced.

An influence of the elliptical arc shape on cooling performance is checked by using the model of Fig. 16 with L = 0.5 x W by varying the fluid vector $\theta$, and a result as set forth in Fig. 18 is obtained. The fluid vector $\theta$ takes a same angle in a counterclockwise direction about the x direction (that is, $\theta = 0°$ or 180°) when the fluid vector $\theta$ is, for example, 150° and 210°, in which case an influence of the elliptical arc shape on cooling performance is same. Hence, reference may be made to a result when $\theta = 150°$ to check a result when $\theta = 210°$ in Fig. 18.

As is set forth in Fig. 18, a ratio of thermal conductivity to a pressure loss rate rises when the fluid vector $\theta$ is 180°, that is, when the skiving direction coincides with the x direction. A ratio of thermal conductivity to a pressure loss rate further rises when the skiving direction is set at a certain angle with respect to the x direction. To be more specific, it is understood that a ratio of thermal conductivity to a pressure loss rate rises in a case where the fluid vector $\theta$ is 135° to 225°. A case where the fluid vector $\theta$ is 135° to 225° means a case where the refrigerant flow direction is in a range of 0° to 45° with respect to the skiving direction. When the refrigerant flow direction produces an acute angle of greater than 0° and not greater than 45° with respect to the skiving direction as above, it is thought that the refrigerant hits against the midpoint of the fin portion first and then readily flows not only above but also diagonally above the midpoint. In particular, when the refrigerant flow direction produces an acute angle of greater than 0° and not greater than 30° (the fluid vector · of not less than 150° and less than 180°) with respect to the skiving direction, a ratio of thermal conductivity to a pressure loss rate rises. Accordingly, the range specified above can be said as a range of maximum cooling efficiency.

Hence, by forming the multiple fin portions 11c and 12c into an elliptical arc shape and by setting the skiving direction and the refrigerant flow direction to produce an acute angle, cooling performance of the multiple fin portions 11c and 12c can be enhanced. Consequently, radiation efficiency can be enhanced further.

(5) In the semiconductor device of the present embodiment, the recess portions 11d and 12d are located downstream of the fin portions 11c and 12c, respectively, in a flow of the refrigerant. Hence, an influence of the recess portions 11d and 12d on a flow of the refrigerant can be restricted. Consequently, cooling performance can be enhanced further.

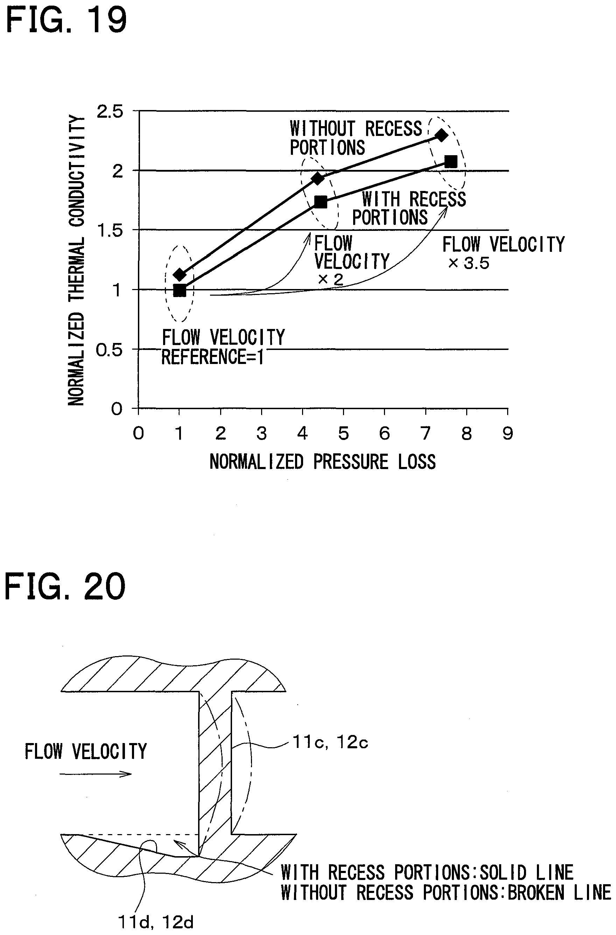

More specifically, an influence of the recess portions 11d and 12d on a flow of the refrigerant is checked by varying a flow velocity in absence of the recess portions 11d and 12d and in presence of the recess portions 11d and 12d. Herein, a lowest flow velocity is normalized to one, and a relationship between a pressure loss and thermal conductivity is checked by varying a multiplying factor of a flow velocity in reference to the normalized flow velocity. A result as is set forth in Fig. 19 is obtained. Because checked pressure loss and thermal conductivity are a pressure loss and thermal conductivity when a flow velocity is normalized, terms, "normalized pressure loss" and "normalized thermal conductivity", are used in Fig. 19. In order to eliminate other influences, a simple straight pin as is shown in Fig, 20 is used as the fin portions 11c and 12c. Cooling performance (thermal conductivity and a pressure loss) is compared between a case indicated by a sold line where the recess portions 11d and 12d are present and a case indicated by a broken line where the recess portions 11d and 12d are absent.

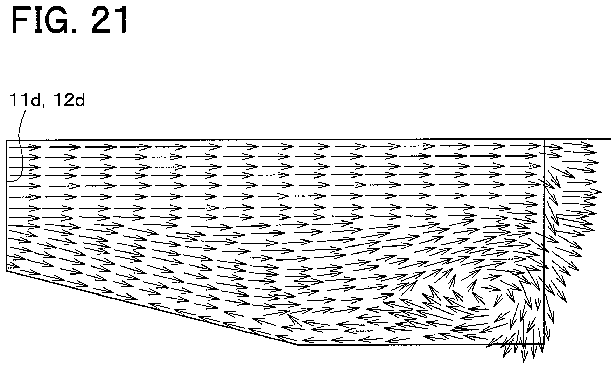

As is set forth in Fig. 19, a comparison between the cases where the recess portions 11d and 12d are present and absent at a same flow velocity reveals that a difference in pressure loss is small whereas a difference in thermal conductivity is large and a difference increases as a flow rate rises. Such differences are obvious in the flow velocity contour shown in Fig. 21, and a flow of the refrigerant "splits" at positions of the recess portions 11d and 12d which are the bases of the fin portions 11c and 12c, respectively. Hence, generated heat is not released in a region where the split occurs and such region no longer makes a contribution as a heat-transfer surface. Thermal conductivity is therefore thought to deteriorate as a result.

By forming the fin portions 11c and 12c by skiving, the recess portions 11d and 12d are left naturally. An influence of the recess portions 11d and 12d is lessened by locating the recess portions 11d and 12d downstream of the fin portions 11c and 12c, respectively, in a flow of the refrigerant, that is, behind a flow velocity. A flow velocity falls inevitably behind the fin portions 11c and 12c and a vicinity when viewed from the flow velocity. Hence, by locating the recess portions 11d and 12d behind the fin portions 11c and 12, respectively, where the flow velocity falls, an influence of the recess portions 11d and 12d can be lessened.

In addition, when the model of the fin portions 11c and 12c shown in Fig. 20 is formed into an elliptical arc shape as is indicated by an alternate long and short dash line, a flow of the refrigerant in the z direction also develops as described above. Accordingly, the refrigerant flows also into the recess portions 11d and 12d and regions inside the recess portions 11d and 12d are also used as a heat-transfer surface. The configuration as above is thus effective in restricting an influence given when the recess portions 11d and 12d are left. In particular, by locating the fin portions 11c and 12c of an elliptical arc shape with the protruding surface side faced upstream in a flow of the refrigerant as in the present embodiment, the refrigerant hits against the midpoints of the fin portions 11c and 12c and easily develops a flow in the z direction. Hence, the effects described above can be obtained.

As has been described above, in the semiconductor device of the present embodiment, the fin portions 11c and 12c are formed into an elliptical arc shape by forming the fin portions 11c and 12c by skiving. Hence, a flow of the refrigerant in the height direction of the fin portions 11c and 12c can be developed. Owing to the configurations as above, a semiconductor device capable of having a flat plane before the fin portions 11c and 12c are formed by skiving and cooling the semiconductor module 6 at higher cooling efficiency can be provided.

The recess portions 11d and 12d are located downstream of the fin portions 11c and 12c, respectively, in a flow of the refrigerant. The fin portions 11c and 12c are formed into an elliptical arc shape and the protruding surface side is located upstream of the recessed surface side in a flow of the refrigerant. A skiving direction of the fin portions 11c and 12c and the refrigerant flow direction are set to produce an acute angle. Owing to the configurations as above, a semiconductor device capable of cooling the semiconductor module 6 at further higher cooling efficiency can be provided.

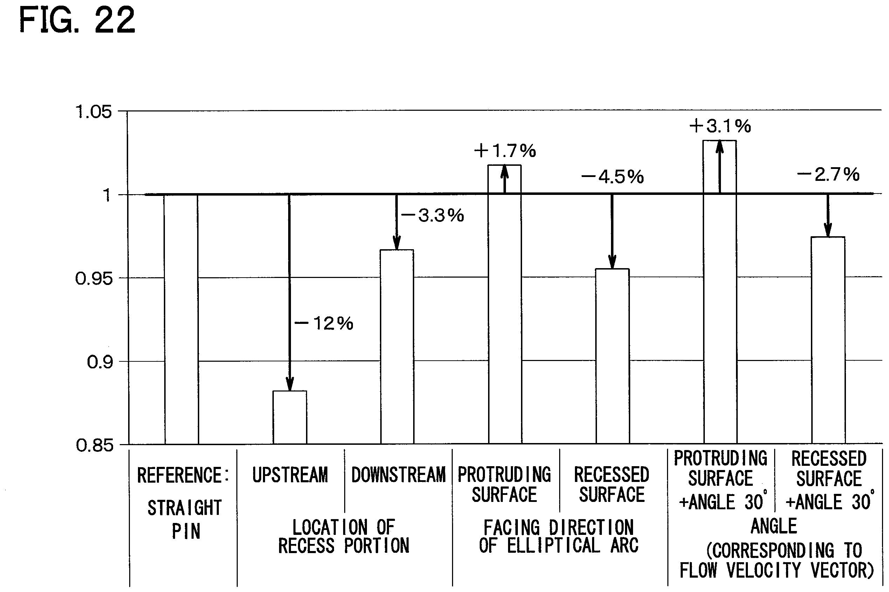

For further information, cooling efficiency by the straight fin used in the evaluation in Fig. 19 at the flow velocity x 2 is set to one as a reference, and cooling performance of a semiconductor device depending on absence and presence of the respective configurations is checked. A result set forth in Fig. 22 is obtained.

As is set forth in Fig. 22, it is confirmed that an influence of the recess portions 11d and 12d depends most significantly on a positional relationship, and the result indicates that it is preferable to provide the recess portions 11d and 12d behind the flow velocity with respect to the fin portions 11c and 12c. When the fin portions 11c and 12c of an elliptical arc shape are compared between cases where the protruding surface side and the recessed surface side are faced upstream in a flow of the refrigerant, the result indicates that it is preferable to face the protruding surface side upstream because a secondary flow in the z direction develops more readily and radiation performance is enhanced.

By setting the skiving direction of the fin portions 11c and 12c to produce an acute angle (for example, 30°) with respect to the refrigerant flow direction by setting the flow velocity vector θ within a predetermined angle range, radiation performance is enhanced in comparison with a case where the skiving direction and the refrigerant flow direction are set in a same direction. In a case where the skiving direction and the refrigerant flow direction are set to produce an acute angle, when the fin portions 11c and 12c are formed into an elliptical arc shape, radiation performance is enhanced whether the protruding surface side or the recessed surface side is faced upstream in a flow of the refrigerant.

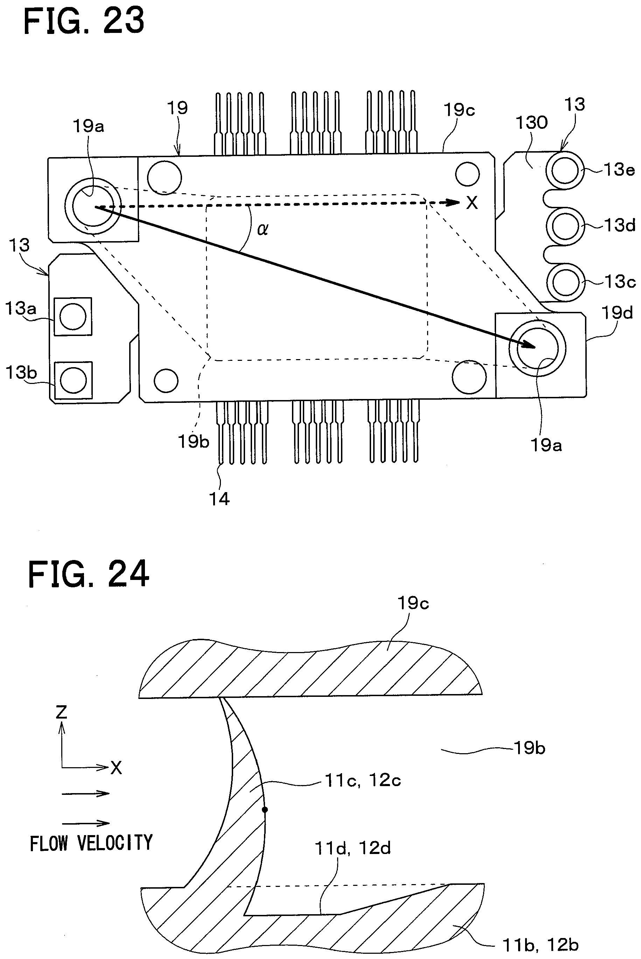

The fin portions 11c and 12c may be machined after the skiving in such a manner that a facing direction of the protruding surfaces of the fin portions 11c and 12c produces an acute angle with respect to the refrigerant flow direction while turning the skiving direction of the fit portions 11c and 12d (the x direction in the drawing) to the refrigerant flow direction. However, such machining is quite difficult. In the present embodiment, by contrast, as is shown in Fig. 23, the through-holes 19a on the refrigerant introducing and discharging sides are located at diagonally opposing corners of the radiator plates 11 and 12 of substantially a rectangular shape on front and back surface sides where the multiple fin portions 11c and 12c are provided respectively. That is, a straight line linking centers of the respective through-holes 19a and the x direction are set to produce an acute angle α greater than 0° and not greater than 45° while setting the skiving direction of the fin portions 11c and 12c and the facing direction of the protruding surfaces in a same direction. Consequently, the skiving direction of the fin portions 11c and 12c, that is, the facing direction of the protruding surfaces and the refrigerant flow direction produce the angle α.

Second Embodiment

A second embodiment of the present disclosure will be described. The present embodiment is same as the first embodiment above except that a shape of fin portions 11c and 12c is changed from the shape described in the first embodiment above, and therefore will describe only a difference from the first embodiment above.

As is shown in Fig. 24, the fin portions 11c and 12c are formed into an elliptical arc shape by skiving surfaces of inner portions 11b and 12b, respectively, in the present embodiment, too. However, a protruding surface side of the fin portions 11c and 12c is faced downstream in a flow of a refrigerant and a recessed surface side is faced upstream in the flow of the refrigerant.

When the recessed surface is faced upstream in the flow of the refrigerant as above, cooling efficiency deteriorates to some extent in comparison with the configuration described above with reference to Fig. 23 in which the protruding surface is faced upstream in the flow of the refrigerant. However, effects same as the effects of the first embodiment above can be obtained basically.

When the fin portions 11c and 12c are formed by skiving, a skived portion readily takes a shape of the present embodiment. Hence, the skived portion can be easily machined to the fin portions 11c and 12c having a structure of the present embodiment. By contrast, the structure of the first embodiment above requires machining to shape the fin portions 11c and 12c after skiving, and machining is more difficult than the structure of the present embodiment. Consequently, a manufacturing process of a semiconductor device having the structure of the present embodiment can be simpler.

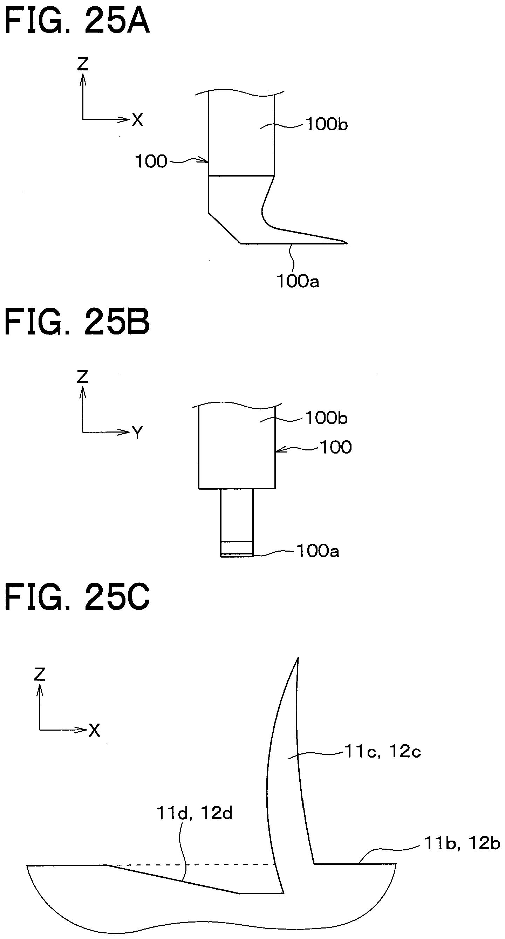

For example, the fin portions 11c and 12c are formed by skiving using a skiving tool 100 with a cutting edge 100a as are shown in Fig. 25A and Fig. 25B. The cutting edge 100a is of an L shape bent from a base 100b in a perpendicular direction, and has a linear tip end. The surfaces of inner portions 11b and 12b are skived with the skiving tool 100 having the cutting edge 100a gradually deeper to a skiving intermediate position and skived at a constant depth after the skiving intermediate position. Consequently, as is shown in Fig. 25C, recess portions 11d and 12d are left and the fin portions 11c and 12c with the protruding surface side faced to an opposite side to the recess portions 11d and 12d and the recessed surface side faced to the recess portions 11d and 12d can be formed.

Third Embodiment

A third embodiment of the present disclosure will be described. The present embodiment is same as the first embodiment above except that a shape of fin portions 11c and 12c and a shape of a blade edge 100a of a skiving tool 100 used to form the fin portions 11c and 12c are changed from the shapes described in the second embodiment above, and therefore will describe only a different from the first embodiment above.

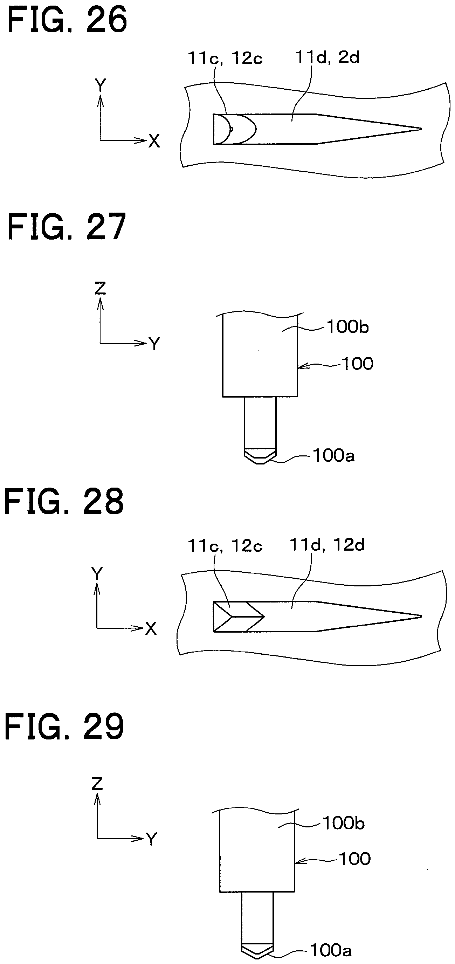

As is shown in Fig. 26, in the present embodiment, skived surfaces of the fin portions 11c and 12c are not flat surfaces and formed into curved surfaces protruding toward recess portions 11d and 12d.

As has been described, the recess portions 11d and 12d give an influence on a flow of a refrigerant. However, an influence on a flow of the refrigerant is lessened as a volume of the recess portions 11d and 12d is reduced. When a pressure loss is taken into consideration, the fin portions 11c and 12c of a circular shape in cross section are advantageous.

In the first and second embodiments above, the fin portions 11c and 12c are of a rectangular shape in cross section and a recess portion is also of a rectangular shape in cross section. By contrast, in the present embodiment, skived surfaces of the fin portions 11c and 12c are formed into curved surfaces, to be more specific, elliptical arc surfaces. Hence, according to a structure of the present embodiment, a reduction in flow velocity of the refrigerant can be restricted on a side of the surfaces of the fin portions 11c and 12c located downstream in a flow of the refrigerant. Also, according to the structure of the present embodiment, the recess portions 11d and 12d are not of a rectangular shape in cross section and formed into a corner-less shape Instead. Hence, a volume of the recess portions 11d and 12d can be reduced by the structure of the present embodiment in comparison with the structures of the first and second embodiments above. Consequently, an influence of the recess portions 11d and 12d on a flow of the refrigerant can be lessened, which can in turn enhance cooling performance further.

The structure as above can be obtained through machining by changing a tip end shape of the cutting edge 100a of the skiving tool 100 as is shown in Fig. 27. That is, by changing a shape of the cutting edge 100a to a half elliptical arc shape, skived surfaces of the fin portions 11c and 12c formed by skiving can be curved surfaces of elliptical arc shape in cross section.

Modification of Third Embodiment

The third embodiment has described the fin portions 11c and 12c having curved surfaces of an elliptical arc shape in cross section as an example of the fin portions 11c and 12c having tapered skived surfaces. However, the skived surfaces of the fin portions 11c and 12c may be of other tapered shapes, for example, V-shaped surfaces as is shown in Fig. 28. Even when configured as above, effects same as the effects of the third embodiment can be obtained. Such a structure can be obtained through machining using the skiving tool 100 having a V-shaped cutting edge 100a as is shown in Fig. 29.

Fourth Embodiment

A fourth embodiment of the present disclosure will be described. The present embodiment is same as the first embodiment above except that multiple semiconductor modules 6 same as the semiconductor module 6 of the first embodiment above are stacked, and therefore will describe only a difference from the first embodiment above.

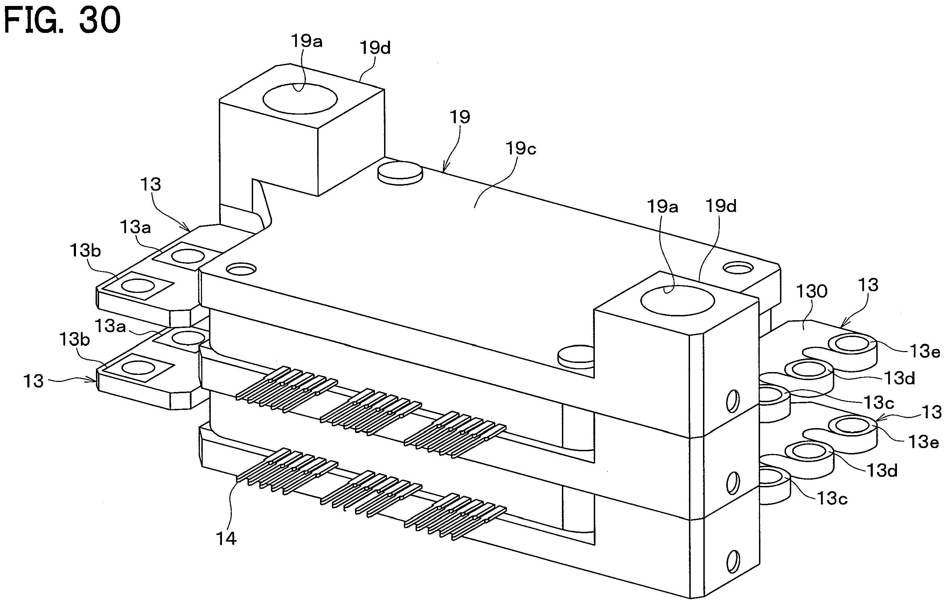

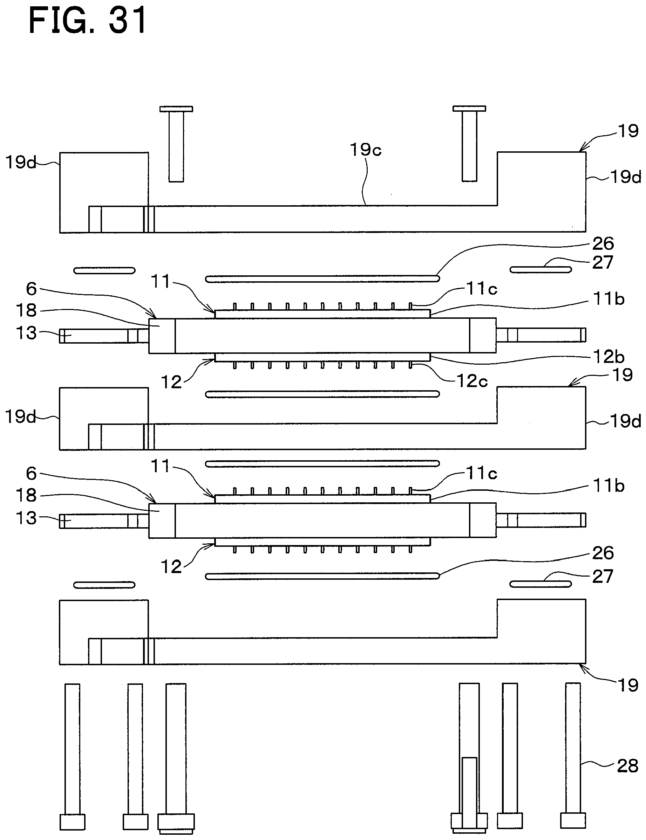

As are shown in Fig. 30 and Fig. 31, a structure of the present embodiment includes two semiconductor modules 6, and the two semiconductor modules 6 are interposed among three coolers 19. More specifically, one semiconductor module 6 is disposed on each side of one cooler 19, and one cooler 19 is disposed on each side of the two semiconductor modules 6 sandwiching the one cooler 19.

Although it is not shown in Fig. 30 and Fig. 31, the cooler 19 sandwiched between the two semiconductor modules 6 is provided with openings 19e on both main and back surface sides. An inner portion 11b and fin portions 11c of an upper radiator plate 11 of one semiconductor module 6 are inserted into one opening 19e and an inner portion 12b and fin portions 12c of a lower radiator plate 12 of the other semiconductor module 6 are inserted into the other opening 19e.

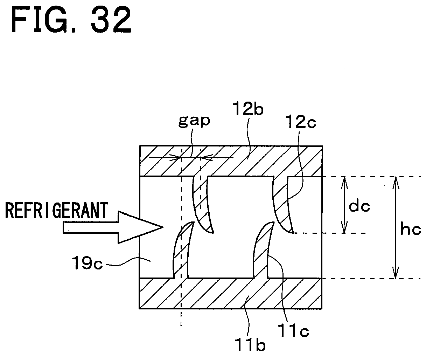

Both of the fin portions 11c and 12c are inserted into the cooler 19 sandwiched between the two semiconductor modules 6. Hence, as is shown in Fig. 32, tip ends of the fin portions 11c and 12c are displaced not to overlap each other. A dimension hc of a flow passage 19b provided to the cooler 19 in a height direction of the fin portions 11c and 12c is set to be less than a total of heights of the both fin portions 11c and 12c, 2 x dc. According to such a structure, no clearance is formed between the fin portions 11c and 12c at tip ends. A refrigerant is thus prevented from bypassing the fin portions 11c and 12c by flowing through a clearance. Consequently, cooling efficiency can be enhanced.

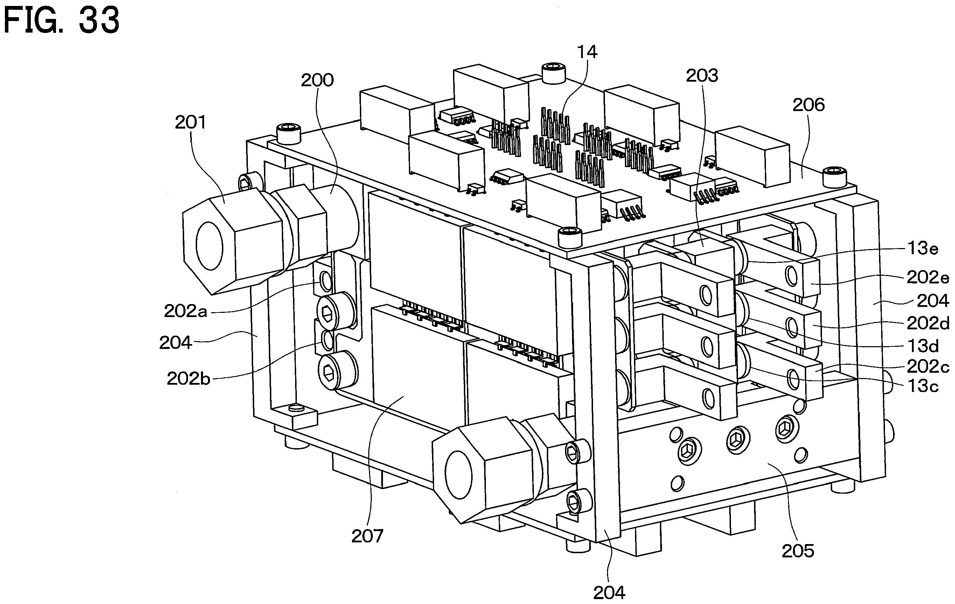

A semiconductor device including the multiple semiconductor modules 6 stacked as above is applied to, for example, an inverter unit shown in Fig. 33. The inverter unit shown in Fig. 33 is of substantially a rectangular shape and a pipe member 200 is provided on one surface side. The pipe member 200 is connected to a passage forming portion 19b in a stacking direction of the semiconductor modules 6 and the coolers 19. A nut portion 201 is provided to a tip end of the pipe member 200. The refrigerant is introduced and discharged by connecting the pipe member 200 to another unillustrated pipe member or the like with the nut portion 201.

One end of a multi-layer wiring bus bar 13 protrudes from one surface, to which a direction orthogonal to the stacking direction of the semiconductor modules 6 and the coolers 19 is normal, and the other end of the multi-layer wiring bus bar 13 protrudes from a surface opposite to the firstly-mentioned surface. A positive-electrode terminal 202a and a negative-electrode terminal 202b are connected, respectively, to a positive-electrode terminal 13a and a negative-electrode terminal 13b provided to the multi-layer wiring bus bar 13 at one end. Power is supplied by connecting a positive electrode and a negative electrode of an unillustrated power source to the terminals 202a and 202b, respectively. U-, V-, and W-terminals 202c through 202e are connected, respectively, to U- through W-terminals 13c through 13e disposed to the multi-layer wiring bus bar 13 at the other end. A current is supplied phase by phase by connecting U- through W-terminals of an unillustrated motor driven by the inverter unit to the terminals 202c through 202e, respectively.

The present embodiment has described an example where two semiconductor modules 6 are included. It should be appreciated that, for example, a step-up function can be enhanced by stacking a larger number of the semiconductor modules 6. Hence, the present embodiment is available for an electric system required to have a step-up function.

By connecting the U- through W-terminals 13c through 13e of the two semiconductor modules 6 to the U- through W-terminals of a same motor, the motor can be driven by the two semiconductor modules 6 in parallel. By connecting the U- through W-terminals 13c through 13e of the two semiconductor modules 6 to U- through W-terminals of different motors, the two motors can be driven. In such a case, by connecting the positive and negative electrodes 13a and 13b of the two semiconductor modules 6 to different power supplies, two motors can be driven on different voltages.

In such a case, it is necessary to provide insulation between the adjacent semiconductor modules 6 for the positive and negative electrodes 13a and 13b and the U- through W-terminals 13c through 13e. Hence, as is shown in Fig. 32, it is preferable to provide a spacer 203 made of an insulating material between the adjacent positive and negative electrodes 13a and 13b and between the adjacent U- through W-terminals 13c through 13e.

The inverter unit is enclosed by an outer frame portion including pillar stays 204 disposed at four corners, and supporting members 205 extending in the stacking direction of the semiconductor modules 6 and each connecting two stays 204. A printed circuit board 206 provided with control circuits is fastened with screws at both ends of the respective stays 204 of the outer frame portion. By inserting control terminals 14 into through-holes provided to the printed circuit board 206 and soldering control terminals 14 to the printed circuit board 206, the control terminals 14 and the control circuits are electrically connected. A capacitor module 207 forming a smoothing capacitor 4 is fixed to a surface of the cooler 19 on a side where the pipe member 200 is provided. The capacitor module 207 is, for example, a ceramic capacitor made of barium titanate having a high dielectric constant, and formed as a plate-shaped member. The capacitor module 207 may be a film capacitor made of a PP material. However, by using a compact, high-capacity ceramic capacitor, the capacitor module 207 can be mounted by utilizing a small space only large enough to dispose the cooler 19. The inverter unit can be thus reduced in size.

As has been described, the structure including multiple semiconductor modules 6 can be realized. An inverter unit can be formed by adopting the structure including multiple semiconductor modules 6 as above.

Other Embodiments

Basically, any structure in which skived fin portions 11c and 12c are of an elliptical arc shape tapered toward a tip end and a skiving direction and a refrigerant flow direction produce an acute angle is available. For example, through-holes 19a used to introduce and discharge a refrigerant are not necessarily provided at diagonally opposing corners of upper and lower radiator plates 11 and 12 of a rectangular shape and provided with the fin portions 11c and 12c, respectively. The fin portions 11c and 12c and the through-holes 19a used to introduce and discharge the refrigerant are not necessarily located at the positions specified in the respective embodiments above provided that the skiving direction and the refrigerant flow direction produce an acute angle.

The above has described the semiconductor switching elements 51a through 56a as an example of heater elements. However, the present disclosure is also applicable to a semiconductor device of any other configuration as long as the semiconductor device is provided with semiconductor elements functioning as heater elements and cools the semiconductor elements using a cooler 19.

The fin portions 11c and 12c described above are of an elliptical arc shape. The term, "elliptical arc shape", referred to herein includes a circular arc shape. Also, the fin portions 11c and 12c described above are formed at a same thickness from the base to the midpoint and tapered by gradually reducing the thickness from the midpoint toward the tip end. However, the fin portions 11c and 12c may be of a tapered shape that gradually becomes thinner entirely from base to tip.

The embodiments above have described that the positive electrode and the negative electrode of the DC power supply 2 as an external power supply are directly connected to the positive-electrode terminal 13a and the negative-electrode terminal 13b, respectively. However, the positive-electrode terminal 13a is a terminal to which a voltage is applied from the external power supply and the negative-electrode terminal 13b is a terminal connected to a low potential point. Hence, an element, such as a resistor, may be provided between the positive-electrode terminal 13a and the external power supply or between the negative-electrode terminal 13b and a ground potential point.

While the present disclosure has been described with reference to embodiments thereof, it is to be understood that the disclosure is not limited to the embodiments and constructions. The present disclosure is intended to cover various modification and equivalent arrangements. In addition, while the various combinations and configurations, other combinations and configurations, including more, less or only a single element, are also within the scope of the present disclosure.

**Claims**

1. A semiconductor device comprising:

   at least one semiconductor module (6) having a semiconductor element (51a through 56a) functioning as a heater element, a resin mold (18) having a plate shape and covering the semiconductor element, and a heat radiation plate (11, 12) covered by the resin mold, exposed from one surface of the resin mold, insulated from the semiconductor element, and radiating heat generated in the semiconductor element; and
   a cooler (19) disposed on a surface of the semiconductor module where the heat radiation plate is exposed, providing a refrigerant passage (19b), and promoting radiation of heat from the heat radiation plate (11, 12) by flowing a refrigerant through the refrigerant passage, wherein:

   the heat radiation plate includes fins (11c, 12c) provided by pulling up a surface of the radiation plate (11, 12) along one direction (y) linearly; and
   the fins have a tapered shape with an elliptical arc shape curved from a base to a tip, **characterized in that**
   the surface of the radiation plate (11, 12) includes a protruding surface of fin portions (11c, 12c) and a recessed surface (11d, 12d);
   the recessed surface (11d, 12d) is provided by a skived side of the surface of the radiation plate (11, 12); and
the protruding surface (11c, 12c) is provided by an inner portion opposite to the skived side; and
a skiving direction (B1) of the multiple fin portions (11c, 12c) has an acute angle ($\alpha$) with respect to the refrigerant flow direction (A1), the angle being greater than 0° and not greater than 45°.

2. The semiconductor device according to claim 1, wherein:

   a protruding surface side of the fin with the elliptical arc shape is directed to an upstream side in a flow of the refrigerant; and
   a recessed surface side of the fin is directed to a downstream side in the flow of the refrigerant.

3. The semiconductor device according to claim 1, wherein:

   a recessed surface side of the fin with the elliptical arc shape is directed to an upstream side in a flow of the refrigerant; and
   a protruding surface side of the fin is directed to a downstream side in the flow of the refrigerant.

4. The semiconductor device according to any one of claims 1 through 3, wherein:
   a recess portion (11d, 12d) provided by pulling up the fin is located on a downstream side of the fin.

5. The semiconductor device according to any one of claims 1 through 4, wherein:

   the heat radiation plate includes an outer edge portion (11a, 12a) of the heat radiation plate and an inner portion (11b, 12b) arranged on an inner side of the outer edge portion;
   the inner portion protrudes from the outer edge portion, and the fin is provided by pulling up a surface of the inner portion;
   the cooler has a hollow plate portion (19c) for providing the refrigerant passage;
   the hollow plate portion includes an opening (19e) which is communicated with the refrigerant passage and in which the inner portion and the fin are inserted; and
   a thickness of a surface of the hollow plate portion where the opening is arranged defines an amount of protrusion of the inner portion from the outer edge portion.

6. The semiconductor device according to claim 5, wherein:
   a dimension of the refrigerant passage in a height direction of the fin is less than a height of the fin.

7. The semiconductor device according to claim 5, wherein:

the at least one semiconductor module includes two semiconductor modules;

two semiconductor modules are arranged to sandwich the cooler;

each surface of the hollow plate portion of the cooler where two semiconductor modules are respectively disposed has the opening in which the fin and the inner portion of the radiator plate equipped with each semiconductor module are inserted;

a dimension of the refrigerant passage in a height direction of the fin is less than a total of a height of the fin in the two semiconductor modules; and

a location of the fin in each of the two semiconductor modules is displaced from each other in a surface direction of the inner portion of a respective semiconductor module.

8. The semiconductor device according to any one of claims 1 through 7, wherein:
a cross section of a pulling-up surface of the fin is a tapered shape.


**Patentansprüche**

1. Halbleitervorrichtung, die aufweist:

mindestens ein Halbleitermodul (6), das ein Halbleiterelement (51a bis 56a), das als ein Heizelement dient, eine Harzform (18), die eine Plattengestalt aufweist und das Halbleiterelement bedeckt, und eine Wärmeabgabeplatte (11, 12) aufweist, die von der Harzform bedeckt ist, von einer Oberfläche der Harzform freiliegt, gegenüber dem Hableiterelement isoliert ist und Wärme, die in dem Halbleiterelement erzeugt wird, abgibt; und

einen Kühler (19), der auf einer Oberfläche des Halbleitermoduls angeordnet ist, bei der die Wärmeabgabeplatte freiliegt, eine Kühlmittelpassage (19b) bereitstellt und eine Abgabe von Wärme von der Wärmeabgabeplatte (11, 12) dadurch fördert, dass ein Kühlmittel durch die Kühlmittelpassage fließt, wobei

die Wärmeabgabeplatte Rippen (11c, 12c) enthält, die durch lineares Hochziehen einer Fläche der Abgabeplatte (11, 12) entlang einer Richtung (y) bereitgestellt wird; und

die Rippen eine sich verjüngende Gestalt mit einer elliptischen Bogengestalt aufweisen, die von einer Basis zu einer Spitze gekrümmt ist,

**dadurch gekennzeichnet, dass**

die Fläche der Abgabeplatte (11, 12) eine vorstehende Fläche von Rippenabschnitten (11c, 12c) und eine vertiefte Fläche (11d, 12d) enthält;

die vertiefte Fläche (11d, 12d) durch eine abgeschälte Seite der Fläche der Abgabeplatte (11, 12) bereitgestellt wird; und

die vorstehende Fläche (11c, 12c) durch einen inneren Abschnitt entgegengesetzt zu der abgeschälten Seite bereitgestellt wird; und

eine Abschälrichtung (B1) der Rippenanschnitte (11c, 12c) einem spitzen Winkel (a) in Bezug auf die Kühlmittelfließrichtung (A1) aufweist, wobei der Winkel größer als 0° und nicht größer als 45° ist.

2. Halbleitervorrichtung nach Anspruch 1, wobei
die Seite der vorstehenden Fläche der Rippe mit der elliptischen Bogengestalt zu einer Stromaufseite eines Fließens des Kühlmittels gerichtet ist; und
die Seite der vertieften Fläche der Rippe zu einer Stromabseite des Fließens des Kühlmittels gerichtet ist.

3. Halbleitervorrichtung nach Anspruch 1, wobei
die Seite der vertieften Fläche der Rippe mit der elliptischen Bogengestalt zu einer Stromaufseite eines Fließens des Kühlmittels gerichtet ist; und
die Seite der vorstehenden Fläche der Rippe zu einer Stromabseite des Fließens des Kühlmittels gerichtet ist.

4. Halbleitervorrichtung nach einem der Ansprüche 1 bis 3, wobei
ein Vertiefungsabschnitt (11d, 12d), der durch Hochziehen der Rippe bereitgestellt wird, auf einer Stromabseite der Rippe angeordnet ist.

5. Halbleitervorrichtung nach einem der Ansprüche 1 bis 4, wobei
die Wärmeabgabeplatte einen Außenkantenabschnitt (11a, 12a) der Wärmeabgabeplatte und einen inneren Abschnitt (11b, 12b) enthält, der auf einer Innenseite des Außenkantenabschnittes angeordnet ist;
der innere Abschnitt von dem Außenkantenabschnitt vorsteht und die Rippe durch Hochziehen einer Fläche des inneren Abschnitts bereitgestellt wird;
der Kühler einen hohlen Plattenabschnitt (19c) zum Bereitstellen der Kühlmittelpassage aufweist;
der hohle Plattenabschnitt eine Öffnung (19e) enthält, die mit der Kühlmittelpassage kommuniziert und in die der innere Abschnitt und die Rippe eingeführt sind; und
eine Dicke einer Fläche des hohlen Plattenabschnitts, bei der die Öffnung angeordnet ist, eine Größe eines Vorstehens des inneren Abschnitts gegenüber dem Außenkantenabschnitt definiert.

**6.** Halbleitervorrichtung nach Anspruch 5, wobei eine Abmessung der Kühlmittelpassage in einer Höhenrichtung der Rippe kleiner als eine Höhe der Rippe ist.

**7.** Halbleitervorrichtung nach Anspruch 5, wobei das mindestens eine Halbleitermodul zwei Halbleitermodule enthält; zwei Halbleitermodule derart angeordnet sind, dass sie den Kühler zwischen sich aufnehmen; jede Oberfläche des hohlen Plattenabschnitts des Kühlers, bei der zwei Halbleitermodule jeweils angeordnet sind, die Öffnung aufweist, in die die Rippe und der innere Abschnitt der Abgabeplatte, die mit jedem Halbleitermodul ausgerüstet ist, eingeführt sind; eine Abmessung der Kühlmittelpassage in einer Höhenrichtung der Rippe kleiner als eine Gesamthöhe der Rippe in den beiden Halbleitermodulen ist; und ein Ort der Rippe in den jeweiligen beiden Halbleitermodulen gegenüber dem anderen in einer Flächenrichtung des inneren Abschnitts eines jeweiligen Halbleitermoduls versetzt ist.

**8.** Halbleitervorrichtung nach einem der Ansprüche 1 bis 7, wobei ein Querschnitt einer hochgezogenen Fläche der Rippe eine sich verjüngende Gestalt ist.

## Revendications

**1.** Dispositif à semi-conducteur comprenant :

au moins un module semi-conducteur (6) ayant un élément semi-conducteur (51a à 56a) fonctionnant comme un élément chauffant, un moule en résine (18) ayant une forme de plaque et recouvrant l'élément semi-conducteur, et une plaque de rayonnement de chaleur (11, 12) recouverte par le moule en résine, exposée depuis une surface du moule en résine, isolée de l'élément semi-conducteur et faisant rayonner la chaleur générée dans l'élément semi-conducteur ; et un refroidisseur (19) disposé sur une surface du module semi-conducteur où la plaque de rayonnement de chaleur est exposée, fournissant un passage pour fluide frigorigène (19b), et favorisant le rayonnement de chaleur depuis la plaque de rayonnement de chaleur (11, 12) en faisant s'écouler un fluide frigorigène à travers le passage pour fluide frigorigène, dans lequel :

la plaque de rayonnement de chaleur inclut des ailettes (11c, 12c) fournies en remontant une surface de la plaque de rayonnement (11, 12) le long d'une direction (y) linéairement ; et les ailettes ont une forme conique avec une forme d'arc elliptique incurvée d'une base à une pointe, **caractérisé en ce que** la surface de la plaque de rayonnement (11, 12) inclut une surface saillante de portions d'ailette (11c, 12c) et une surface évidée (11d, 12d) ; la surface évidée (11d, 12d) est fournie par un côté biseauté de la surface de la plaque de rayonnement (11, 12) ; et la surface saillante (11c, 12c) est fournie par une portion intérieure opposée au côté biseauté ; et une direction de biseautage (B1) des multiples portions d'ailette (11c, 12c) a un angle aigu (a) par rapport à la direction d'écoulement de fluide frigorigène (A1), l'angle étant supérieur à 0° et ne dépassant pas 45°.

**2.** Dispositif à semi-conducteur selon la revendication 1, dans lequel :

un côté de surface saillante de l'ailette avec la forme d'arc elliptique est dirigé vers un côté amont dans un écoulement du fluide frigorigène ; et un côté de surface évidée de l'ailette est dirigé vers un côté aval dans l'écoulement du fluide frigorigène.

**3.** Dispositif à semi-conducteur selon la revendication 1, dans lequel :

un côté de surface évidée de l'ailette avec la forme d'arc elliptique est dirigé vers un côté amont dans un écoulement du fluide frigorigène ; et un côté de surface saillante de l'ailette est dirigé vers un côté aval dans l'écoulement du fluide frigorigène.

**4.** Dispositif à semi-conducteur selon l'une quelconque des revendications 1 à 3, dans lequel : une portion d'évidement (11d, 12d) fournie en remontant l'ailette est située sur un côté aval de l'ailette.

**5.** Dispositif à semi-conducteur selon l'une quelconque des revendications 1 à 4, dans lequel :

la plaque de rayonnement de chaleur inclut une portion de bord extérieur (11a, 12a) de la plaque de rayonnement de chaleur et une portion intérieure (11b, 12b) agencée sur un côté intérieur de la portion de bord extérieur ; la portion intérieure fait saillie depuis la portion de bord extérieur, et l'ailette est fournie en remontant une surface de la portion intérieure ;

le refroidisseur comporte une portion de plaque creuse (19c) pour fournir le passage pour fluide frigorigène ;

la portion de plaque creuse inclut une ouverture (19e) qui communique avec le passage pour fluide frigorigène et dans laquelle la portion intérieure et l'ailette sont insérées ; et

une épaisseur d'une surface de la portion de plaque creuse où l'ouverture est agencée définit une quantité de saillie de la portion intérieure depuis la portion de bord extérieur.

6. Dispositif à semi-conducteur selon la revendication 5, dans lequel :

une dimension du passage pour fluide frigorigène dans une direction de hauteur de l'ailette est inférieure à une hauteur de l'ailette.

7. Dispositif à semi-conducteur selon la revendication 5, dans lequel :

l'au moins un module semi-conducteur inclut deux modules semi-conducteurs ;

deux modules semi-conducteurs sont agencés pour prendre en sandwich le refroidi sseur ;

chaque surface de la portion de plaque creuse du refroidisseur où deux modules semi-conducteurs sont respectivement disposés possède l'ouverture dans laquelle sont insérées l'ailette et la portion intérieure de la plaque de radiateur équipée de chaque module semi-conducteur ;

une dimension du passage pour fluide frigorigène dans une direction de hauteur de l'ailette est inférieure à un total d'une hauteur de l'ailette dans les deux modules semi-conducteurs ; et

un emplacement de l'ailette dans chacun des deux modules semi-conducteurs est déplacé l'un par rapport à l'autre dans une direction de surface de la portion intérieure d'un module semi-conducteur respectif.

8. Dispositif à semi-conducteur selon l'une quelconque des revendications 1 à 7, dans lequel :

une coupe transversale d'une surface montante de l'ailette est une forme conique.

FIG. 1

# FIG. 2

EP 3 309 827 B1

# FIG. 3

EP 3 309 827 B1

# FIG. 4

EP 3 309 827 B1

# FIG. 5

EP 3 309 827 B1

FIG. 6

# FIG. 7

# FIG. 8

# FIG. 9

# FIG. 10

FLOW VELOCITY

# FIG. 11

11c, 12c    11d, 12d

$\alpha$

FLOW VELOCITY

Y

X

# FIG. 12

Graph: BYPASS FLOW RATE PROPORTION (%) vs CLEARANCE ABOVE FIN PORTIONS (mm)

# FIG. 13A

# FIG. 13B

# FIG. 14

# FIG. 15A

SH−L

L

# FIG. 15B

FL−L

L

# FIG. 16

J1

h

W L

## FIG. 17

## FIG. 18

## FIG. 19

## FIG. 20

# FIG. 21

11d, 12d

# FIG. 22

-2.7%

+3.1%

-4.5%

+1.7%

-3.3%

-12%

| REFERENCE:<br>STRAIGHT<br>PIN | UPSTREAM | DOWNSTREAM | PROTRUDING<br>SURFACE | RECESSED<br>SURFACE | PROTRUDING<br>SURFACE<br>+ANGLE 30° | RECESSED<br>SURFACE<br>+ANGLE 30° |
|---|---|---|---|---|---|---|
| | LOCATION OF<br>RECESS PORTION | | FACING DIRECTION<br>OF ELLIPTICAL ARC | | ANGLE<br>(CORRESPONDING TO<br>FLOW VELOCITY VECTOR) | |

1.05
1
0.95
0.9
0.85

# FIG. 23

# FIG. 24

# FIG. 25A

# FIG. 25B

# FIG. 25C

# FIG. 26

11c, 12c    11d, 2d

Y
↑
→X

# FIG. 27

Z
↑
→Y

100b
100
100a

# FIG. 28

11c, 12c    11d, 12d

Y
↑
→X

# FIG. 29

Z
↑
→Y

100b
100
100a

FIG. 30

# FIG. 31

# FIG. 32

FIG. 33

**REFERENCES CITED IN THE DESCRIPTION**

**Patent documents cited in the description**

- JP 2015119459 A
- JP 2005216975 A
- US 2011079376 A1
- JP 2007208154 A
- JP 2007123547 A
- US 20130192329 A1